# EUROPEAN PATENT SPECIFICATION

(11) **EP 4 372 989 B1**
(45) Date of publication and mention of the grant of the patent: **09.12.2026**
(21) Application number: 22841399.3
(22) Date of filing: 13.07.2022
(51) Int. Cl.: H03H 9/17, H03H 9/02, H03H 3/02

(54) **BULK ACOUSTIC WAVE RESONANCE DEVICE AND METHOD FOR FORMING SAME, FILTERING DEVICE, AND RADIO FREQUENCY FRONT END DEVICE**
VOLUMENSCHALLWELLENRESONANZVORRICHTUNG UND VERFAHREN ZUR HERSTELLUNG DAVON, FILTERVORRICHTUNG UND HOCHFREQUENZ-FRONTENDVORRICHTUNG
DISPOSITIF DE RÉSONANCE D'ONDES ACOUSTIQUES DE VOLUME ET SON PROCÉDÉ DE FORMATION, DISPOSITIF DE FILTRATION ET DISPOSITIF FRONTAL RADIOFRÉQUENCE

(30) Priority: 16.07.2021 CN 202110808180
(43) Date of publication of application: 22.05.2024
(73) Proprietor: Changzhou Chemsemi Co., Ltd., Changzhou, Jiangsu 213166 (CN)
(72) Inventor: HAN, Xing, Changzhou, Jiangsu 213166 (CN); ZHOU, Jian, Changzhou, Jiangsu 213166 (CN)
(74) Representative: Piticco, Lorena
(86) International application number: PCT/CN2022/105361
(87) International publication number: WO 2023/284766

(56) References cited:
- CN-A- 111 654 259
- CN-A- 111 740 718
- CN-A- 112 039 486
- CN-A- 113 839 640
- CN-A- 113 839 647
- CN-A- 114 421 917
- CN-A- 114 499 451
- JP-A- 2010 130 294
- US-A1- 2018 013 397
- US-A1- 2018 254 764

## Description

### CROSS-REFERENCE TO RELATED APPLICATIONS

This application claims the benefit of priority to Chinese patent application No. 202110808180.6, filed on July 16, 2021, entitled "BULK ACOUSTIC WAVE RESONANCE DEVICE AND METHOD FOR FORMING SAME, FILTERING DEVICE, AND RADIO FREQUENCY FRONT-END DEVICE".

### TECHNICAL FIELD

The present disclosure relates to the technical field of semiconductors, and more particularly to a bulk acoustic wave resonance device and a method for forming the same, a filtering device and a radio frequency front-end device.

### BACKGROUND

A Radio Frequency (RF) front-end chip of a wireless communication device includes a Power Amplifier (PA), an antenna switch, a radio frequency filter, a multiplexer including a duplexer, and a Low Noise Amplifier (LNA), etc. The radio frequency filter includes a Surface Acoustic Wave (SAW) filter, a Bulk Acoustic Wave (BAW) filter, a Micro-Electro-Mechanical System (MEMS) filter, and an Integrated Passive Device (IPD) filter, etc.

As both a SAW resonator and a BAW resonator have a high quality value (Q value), a radio frequency filter including either a SAW resonator, namely a SAW filter, or a BAW resonator, namely a BAW filter, has low insertion loss and high out-band rejection, and thus become a mainstream radio frequency filter applied to wireless communication devices such as mobile phones and base stations. The Q value is a quality factor value of a resonator, and is defined by a center frequency divided by 3 dB bandwidth of the resonator. An effective frequency of a SAW filter typically ranges from 0.4 GHz to 2.7 GHz and an effective frequency of a BAW filter typically ranges from 0.7 GHz to 7 GHz.

BAW resonators have better performance than SAW resonators, but BAW resonators have higher cost than SAW resonators due to more complicated manufacturing process. However, as wireless communication technology gradually evolves, more and more frequency bands are developed. Moreover, due to implementation of frequency band superposition technology such as carrier aggregation, mutual interference between wireless frequency bands becomes increasingly serious. High performance BAW technology can solve the problem of mutual interference between frequency bands. With the advent of the 5G era, wireless mobile networks have adopted higher communication frequency bands, and BAW technology can provide solutions to the filtering problem in the high-frequency band so far.

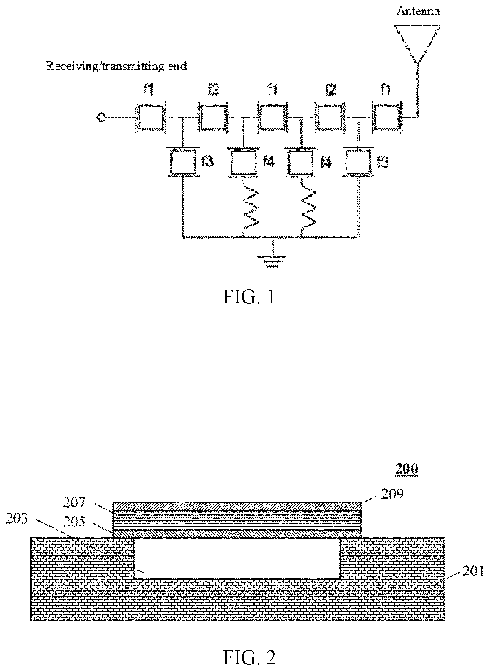

FIG. 1 illustrates a circuit of a BAW filter including a ladder circuit consisting of a plurality of BAW resonators, wherein f1, f2, f3 and f4 represent four different frequencies, respectively. A first end of the circuit is coupled with a receiving/transmitting end, and a second end of the circuit is coupled with an antenna. Within each BAW resonator, alternating voltages with different polarities are supplied to metal electrodes on both sides of a piezoelectric layer of the resonator, an acoustic wave is generated by the piezoelectric layer under the alternating voltages with different polarities, and the acoustic wave within the resonator propagates in a direction perpendicular to the piezoelectric layer. In order to form resonance, the acoustic wave requires total reflection on an upper surface of an upper metal electrode and on a lower surface of a lower metal electrode to form a standing acoustic wave. A condition for an acoustic wave reflection is that acoustic impedance of medium in contact with the upper surface of the upper metal electrode and the lower surface of the lower metal electrode differs greatly from that of the metal electrodes.

Performance of a filter depends on performance of a resonator, which is characterized by parameters such as a minimum series impedance Zₛ, a maximum parallel impedance Zₚ and an electromechanical coupling factor Kt² of the resonator. Zₛ and Zₚ represent electrical losses in the resonator, such as thermal losses, acoustic losses, etc. When the resonator operates at a series resonance frequency fs, a minimum input impedance value Zₛ is obtained; when the resonator operates at a parallel resonance frequency fp, a maximum input impedance Zₚ is obtained. The electromechanical coupling factor Kt² represents a frequency difference between Zₛ and Zₚ, which can affect a passband bandwidth of the RF filter. Resonators with higher Kt² or Zₚ and lower Zs have better performance. A person skilled in the art knows that resonator design requires a trade-off between Kt² and Zₚ, that is, raising Kt² will lead to a reduction to Zₚ, and raising Zₚ will lead to a reduction to of Kt².

A Film Bulk Acoustic wave Resonator (FBAR) is a kind of BAW resonator which can restrain acoustic wave energy inside the resonator. Air or vacuum is configured above a resonance region of the BAW resonator, and a cavity is configured below the resonance region of the BAW resonator. Because acoustic impedance of air and vacuum differs greatly from that of metal electrodes, acoustic waves can be totally reflected on an upper surface of an upper metal electrode and a lower surface of a lower metal electrode to form standing waves.

FIG. 2 illustrates a structural schematic view of an FBAR 200. The FBAR 200 includes: a substrate 201, a cavity 203 disposed in the substrate 201, an electrode layer 205 (i.e., a lower electrode layer) disposed on the substrate 201 and covering the cavity 203, a piezoelectric layer 207 disposed on the electrode layer 205, and an electrode layer 209 (i.e., an upper electrode layer) disposed on the piezoelectric layer 207. An overlap region of the electrode layer 205, the piezoelectric layer 207 and the electrode layer 209 forms a resonance region of the FBAR 200. Two sets of acoustic waves are generated in the resonance region. A first set of acoustic waves includes longitudinal waves and shear waves propagating in a direction perpendicular to the piezoelectric layer 207, and a second set of acoustic waves includes acoustic waves propagating towards a lateral edge of the piezoelectric layer 207, where Rayleigh Lamb waves (RL waves) are included, which propagate along directions parallel to surfaces of two electrode layers to the lateral edge of the piezoelectric layer 207, and resulting in exciting, at the lateral edge, a lateral spurious mode, which leads to a spurious resonance and a reduction to Zₚ and corresponding Q value.

The document CN111740718A discloses a bulk acoustic wave resonance device having multilayer electrodes.

### SUMMARY

An objective of the present disclosure is to provide a bulk acoustic wave resonance device, which can improve a continuity of acoustic waves propagating from a resonance region to an evanescent region, so as to reduce a spurious resonance generated during a propagation process, and decay transverse acoustic waves so as to suppress a lateral spurious mode to improve Zₚ and corresponding Q value as well, and moreover have a small impact on Kt², thereby improving a performance of a filtering device including the bulk acoustic wave resonance device, such as insertion losses and out-band rejection.

An aspect of the present invention provides a bulk acoustic wave resonance device. The bulk acoustic wave resonance device includes: a cavity; a first electrode layer, wherein at least one end of the first electrode layer is disposed above or in the cavity, and the first electrode layer includes a first sub-layer and a second sub-layer contacting the first sub-layer; a piezoelectric layer, wherein the piezoelectric layer includes a first side and a second side opposite to the first side in a vertical direction, wherein the cavity is disposed at the first side, the first electrode layer is disposed at the first side, and the first sub-layer, disposed between the second sub-layer and the piezoelectric layer, contacts the piezoelectric layer; a second electrode layer, disposed at the second side, wherein the second electrode layer includes a third sub-layer and a fourth sub-layer contacting the third sub-layer, the third sub-layer, disposed between the fourth sub-layer and the piezoelectric layer, contacts the piezoelectric layer, and an overlap region of the first sub-layer, the third sub-layer and the piezoelectric layer forms a resonance region; a first passive structure, disposed at the first side and contacting at least one edge of the first sub-layer; and a second passive structure, disposed at the second side and contacting at least one edge of the third sub-layer.

The first passive structure includes: a first raised portion, disposed in the resonance region and having a first overlap portion overlapping with the at least one edge of the first sub-layer, wherein the first raised portion is configured to make acoustic impedance matching of the resonance region and at least one evanescent region outside the resonance region, so that more acoustic waves generated in the resonance region enter the at least one evanescent region; a first passivation portion, disposed between the first raised portion and the first electrode layer for electrically isolating the first passive structure from the first electrode layer; and a first extension portion, disposed outside the resonance region and in the at least one evanescent region for decaying the acoustic waves entering the at least one evanescent region, wherein the first raised portion protrudes relative to the first extension portion.

The second passive structure includes: a second raised portion, disposed in the resonance region and having a second overlap portion overlapping with the at least one edge of the third sub-layer, wherein the second raised portion is configured to make acoustic impedance matching of the resonance region and the at least one evanescent region, so that more acoustic waves generated in the resonance region enter the at least one evanescent region; a second passivation portion, disposed between the second raised portion and the second electrode layer for electrically isolating the second passive structure from the second electrode layer; and a second extension portion, disposed outside the resonance region and in the at least one evanescent region for decaying the acoustic waves entering the at least one evanescent region, wherein the second raised portion protrudes relative to the second extension portion.

According to some embodiments, the at least one edge of the first sub-layer, corresponding to the first passive structure, has a ramp-down shape, and the at least one edge of the third sub-layer, corresponding to the second passive structure, has a ramp-down shape.

According to some embodiments, a dimension of the second sub-layer is smaller than a dimension of the first sub-layer, and a dimension of the fourth sub-layer is smaller than a dimension of the third sub-layer.

According to some embodiments, at least one edge of the second sub-layer is disposed at an inner side to at least one corresponding edge of the first sub-layer, and at least one edge of the fourth sub-layer is disposed at an inner side to at least one corresponding edge of the third sub-layer.

According to some embodiments, the at least one edge of the first sub-layer includes a first edge, and the at least one edge of the second sub-layer includes a second edge, wherein the first edge corresponds to the second edge in the vertical direction, and the second edge is disposed at an inner side to the first edge.

According to some embodiments, the at least one edge of the third sub-layer includes a third edge, and the at least one edge of the fourth sub-layer includes a fourth edge, wherein the third edge corresponds to the fourth edge in the vertical direction, and the fourth edge is disposed at an inner side to the third edge.

According to some embodiments, the first passive structure and the second passive structure surround the resonance region.

According to some embodiments, a thickness of the first passive structure is equal to or less than a thickness of the first electrode layer, and a thickness of the second passive structure is equal to or less than a thickness of the second electrode layer.

According to some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

According to some embodiments, the bulk acoustic wave resonance device further includes: a first electrode extension layer, disposed at the first side and coupled with the first electrode layer; and a second electrode extension layer, disposed at the second side and coupled with the second electrode layer.

According to some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

According to some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

According to some embodiments, a width of the first raised portion is an integer multiple of a half wavelength of the acoustic waves generated in the resonance region, and a width of the second raised portion is an integer multiple of the half wavelength of the acoustic waves generated in the resonance region.

According to some embodiments, the first raised portion is made of a material including a metal, the first extension portion is made of a material including a metal, the second raised portion is made of a material including a metal, and the second extension portion is made of a material including a metal.

According to some embodiments, the first sub-layer is disposed at one side of the first raised portion in the vertical direction, the second sub-layer is disposed at one side of the first raised portion in a horizontal direction, the third sub-layer is disposed at one side of the second raised portion in the vertical direction, and the fourth sub-layer is disposed at one side of the second raised portion in the horizontal direction.

According to some embodiments, the first overlap portion extends to at least one corresponding edge of the second sub-layer in a horizontal direction, and the second overlap portion extends to at least one corresponding edge of the fourth sub-layer in the horizontal direction.

According to some embodiments, a thickness of the first extension portion is less than a thickness of the first electrode layer, and a thickness of the second extension portion is less than a thickness of the second electrode layer.

According to some embodiments, the first extension portion includes a first sub-portion and a second sub-portion, the second sub-portion and the piezoelectric layer are disposed at two opposite sides of the first sub-portion, and a material of the first sub-portion is different from a material of the second sub-portion.

According to some embodiments, the second extension portion includes a third sub-portion and a fourth sub-portion, the fourth sub-portion and the piezoelectric layer are disposed at two opposite sides of the third sub-portion, and a material of the third sub-portion is different from a material of the fourth sub-portion.

According to some embodiments, the first passivation portion is made of a dielectric material, and the second passivation portion is made of a dielectric material.

According to some embodiments, the first passivation portion is further disposed between the piezoelectric layer and the first extension portion, and the second passivation portion is further disposed between the piezoelectric layer and the second extension portion.

According to some embodiments, a first gap is disposed between the first extension portion and the piezoelectric layer, and a second gap is disposed between the piezoelectric layer and the second extension portion.

It should be noted that the raised portions of the passive structures are disposed in the resonance region and have overlap portions overlapping with the electrode layers respectively, which can make acoustic impedance matching of the resonance region and the evanescent region outside the resonance region, so that more acoustic waves generated in the resonance region can propagate into the evanescent region. In addition, the thickness of the raised portion matches with the thickness of the sub-layer of the electrode layer disposed in the horizontal direction, that is, the thickness of the raised portion is approximate to the thickness of the sub-layer, which can improve a continuity of the acoustic waves propagating from the resonance region into the evanescent region so as to reduce a spurious resonance generated during the propagation process. In addition, the cutoff frequency of the evanescent region matches with (for example, equal to or less than) the cutoff frequency of the resonance region, which can decay the acoustic waves entering the evanescent region, so as to suppress lateral spurious mode to improve Zₚ and corresponding Q value, and moreover the impact of the passive structures on Kt² is relatively small. The cutoff frequency is a frequency corresponding to a wave number of 0 on a dispersion curve. Specifically, the reason that the impact of the passive structures on Kt² is relatively small is that the passive structures are not electrically coupled with the electrode layers.

Another embodiment of the present disclosure provides a filtering device. The filtering device includes at least one bulk acoustic wave resonance device according to any one of preceding embodiments.

Another embodiment of the present disclosure provides a radio frequency front-end device. The radio frequency front-end device includes a power amplification device and at least one filtering device according to any one of preceding embodiments, and the power amplification device is coupled with the filtering device.

Another embodiment of the present disclosure provides a radio frequency front-end device. The radio frequency front-end device includes a low noise amplification device and at least one filtering device according to any one of preceding embodiments, and the low noise amplification device is coupled with the filtering device.

Another embodiment of the present disclosure provides a radio frequency front-end device. The radio frequency front-end device includes a multiplexing device, and the multiplexing device includes at least one filtering device according to any one of preceding embodiments.

Another aspect of the present invention provides a method for forming a bulk acoustic wave resonance device, including: forming a piezoelectric layer, wherein the piezoelectric layer includes a first side and a second side opposite to the first side in a vertical direction; forming a first electrode layer at the first side, wherein forming the first electrode layer includes forming a first sub-layer and a second sub-layer contacting the first sub-layer, and the first sub-layer, disposed between the second sub-layer and the piezoelectric layer, contacts the piezoelectric layer; forming a second electrode layer at the second side, wherein forming the second electrode layer includes forming a third sub-layer and a fourth sub-layer contacting the third sub-layer, the third sub-layer, disposed between the fourth sub-layer and the piezoelectric layer, contacts the piezoelectric layer, and an overlap region of the first sub-layer, the third sub-layer and the piezoelectric layer forms a resonance region.

The method further includes: forming a first passive structure at the first side, wherein the first passive structure contacts at least one edge of the first sub-layer; wherein the first passive structure includes a first raised portion, a first passivation portion and a first extension portion, and the first raised portion protrudes relative to the first extension portion; wherein the first raised portion, disposed in the resonance region, has a first overlap portion overlapping with the at least one edge of the first sub-layer, and the first raised portion is configured to make acoustic impedance matching of the resonance region and at least one evanescent region outside the resonance region, so that more acoustic waves generated in the resonance region enter the at least one evanescent region; wherein the first passivation portion is disposed between the first raised portion and the first electrode layer for electrically isolating the first passive structure from the first electrode layer, and the first passivation portion contacts the at least one edge of the first sub-layer; wherein the first extension portion is disposed outside the resonance region and in the at least one evanescent region for decaying the acoustic waves entering the at least one evanescent region.

The method further includes: forming a second passive structure at the second side, wherein the second passive structure contacts at least one edge of the third sub-layer; wherein the second passive structure includes a second raised portion, a second passivation portion and a second extension portion, and the second raised portion protrudes relative to the second extension portion; wherein the second raised portion, disposed in the resonance region, has a second overlap portion overlapping with the at least one edge of the third sub-layer, and the second raised portion is configured to make acoustic impedance matching of the resonance region and the at least one evanescent region, so that more acoustic waves generated in the resonance region enter the at least one evanescent region; wherein the second passivation portion is disposed between the second raised portion and the second electrode layer for electrically isolating the second passive structure from the second electrode layer , and the second passivation portion contacts the at least one edge of the third sub-layer; wherein the second extension portion is disposed outside the resonance region and in the at least one evanescent region for decaying the acoustic waves entering the at least one evanescent region.

According to some embodiments, forming the first sub-layer includes forming a first ramp-down edge corresponding to the first passive structure, and forming the third sub-layer includes forming a second ramp-down edge corresponding to the second passive structure.

According to some embodiments, a dimension of the second sub-layer is smaller than a dimension of the first sub-layer, and a dimension of the fourth sub-layer is smaller than a dimension of the third sub-layer.

According to some embodiments, at least one edge of the second sub-layer is disposed at an inner side to at least one corresponding edge of the first sub-layer, and at least one edge of the fourth sub-layer is disposed at an inner side to at least one corresponding edge of the third sub-layer.

According to some embodiments, the first passive structure and the second passive structure surround the resonance region.

According to some embodiments, a thickness of the first passive structure is equal to or less than a thickness of the first electrode layer, and a thickness of the second passive structure is equal to or less than a thickness of the second electrode layer.

According to some embodiments, forming the first passive structure includes: forming a first passivation layer covering the first electrode layer at the first side; and forming a first overlap layer contacting the first passivation layer and having an overlap portion overlapping with the at least one edge of the first sub-layer; wherein the first passivation layer includes the first passivation portion, and the first overlap layer includes the first raised portion and the first extension portion.

According to some embodiments, forming the second passive structure includes: forming a second passivation layer covering the second electrode layer at the second side; and forming a second overlap layer contacting the second passivation layer and having an overlap portion overlapping with the at least one edge of the third sub-layer; wherein the second passivation layer includes the second passivation portion, and the second overlap layer includes the second raised portion and the second extension portion.

According to some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

According to some embodiments, the method further includes: forming a first electrode extension layer coupling with the first electrode layer at the first side; and forming a second electrode extension layer coupling with the second electrode layer at the second side.

According to some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

According to some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

According to some embodiments, the first overlap portion extends to at least one corresponding edge of the second sub-layer in a horizontal direction, and the second overlap portion extends to at least one corresponding edge of the fourth sub-layer in the horizontal direction.

According to some embodiments, the first sub-layer is disposed at one side of the first raised portion in the vertical direction, the second sub-layer is disposed at one side of the first raised portion in a horizontal direction, the third sub-layer is disposed at one side of the second raised portion in the vertical direction, and the fourth sub-layer is disposed at one side of the second raised portion in the horizontal direction.

According to some embodiments, a thickness of the first extension portion is smaller than a thickness of the first electrode layer, and a thickness of the second extension portion is smaller than a thickness of the second electrode layer.

According to some embodiments, a width of the first raised portion is an integer multiple of a half wavelength of the acoustic waves generated in the resonance region, and a width of the second raised portion is an integer multiple of the half wavelength of the acoustic waves generated in the resonance region.

According to some embodiments, forming the first overlap layer includes forming a first overlap sub-layer and a second overlap sub-layer, the second overlap sub-layer and the piezoelectric layer are disposed at two opposite sides of the first overlap sub-layer, and a material of the first overlap sub-layer is different from a material of the second overlap sub-layer.

According to some embodiments, forming the second overlap layer includes forming a third overlap sub-layer and a fourth overlap sub-layer, the fourth overlap sub-layer and the piezoelectric layer are disposed at two opposite sides of the third overlap sub-layer, and a material of the third overlap sub-layer is different from a material of the fourth overlap sub-layer.

According to some embodiments, the method further includes: forming a first sacrificial layer between the first extension portion and the piezoelectric layer; and forming a second sacrificial layer between the second extension portion and the piezoelectric layer.

According to some embodiments, the method further includes: removing the first sacrificial layer to form a first gap between the first extension portion and the piezoelectric layer; and removing the second sacrificial layer to form a second gap between the second extension portion and the piezoelectric layer.

According to some embodiments, the first passivation portion is further disposed between the piezoelectric layer and the first extension portion, and the second passivation portion is further disposed between the piezoelectric layer and the second extension portion.

### BRIEF DESCRIPTION OF THE DRAWINGS

FIG. 1 illustrates a schematic structural view of a bulk acoustic wave filter circuit, not covered by the invention;
FIG. 2 illustrates a schematic structural view of an FBAR 200;
FIGS. 3 to 6 illustrate schematic structural views of a bulk acoustic wave resonance device 300 according to an embodiment of the present disclosure;
FIG. 7 illustrates a schematic structural view of a hexagonal crystal grain;
FIG. 8(i) illustrates a schematic structural view of an orthorhombic crystal grain;
FIG. 8(ii) illustrates a schematic structural view of a tetragonal crystal grain; and

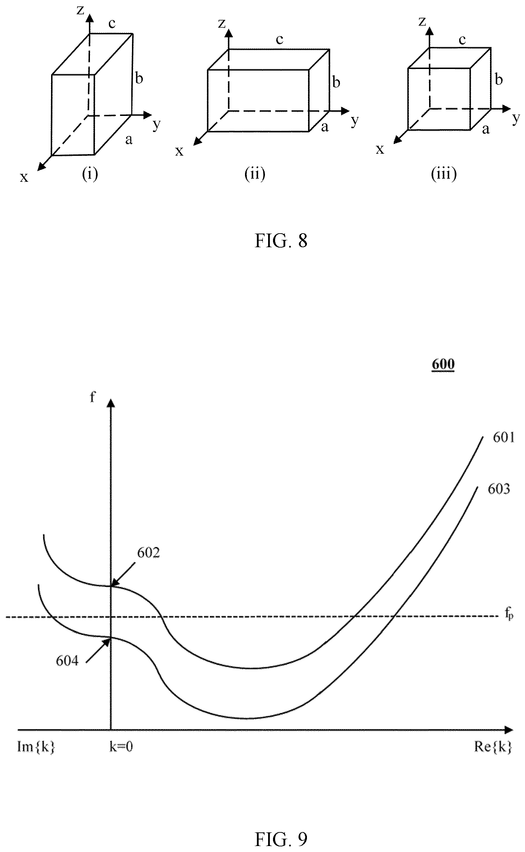

FIG. 8(iii) illustrates a schematic structural view of a cubic crystal grain;
FIG. 9 illustrates a schematic view of an acoustic wave dispersion curve 600 of a bulk acoustic wave resonance device according to an embodiment of the present disclosure;

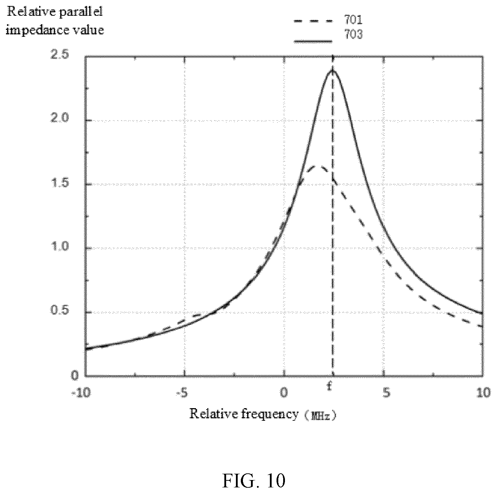

FIG. 10 illustrates a schematic view of a parallel impedance curve 700 of a bulk acoustic wave resonance device according to an embodiment of the present disclosure;

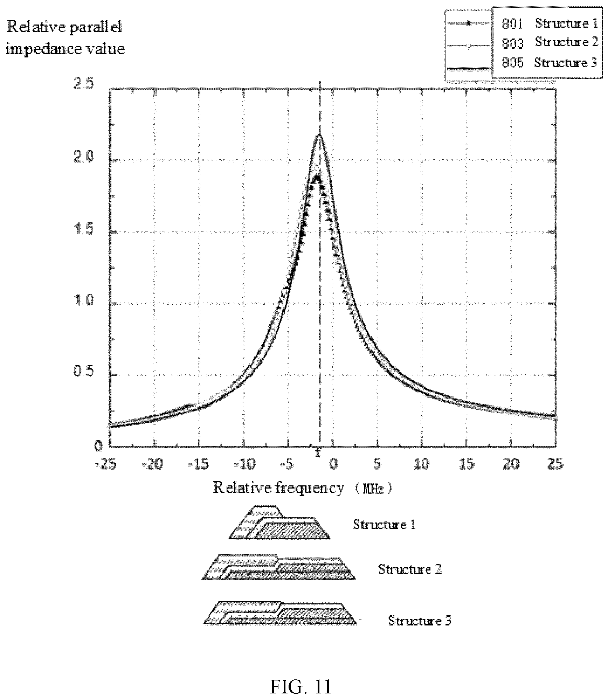

FIG. 11 illustrates a schematic view of a parallel impedance curve 800 of a bulk acoustic wave resonance device according to an embodiment of the present disclosure;

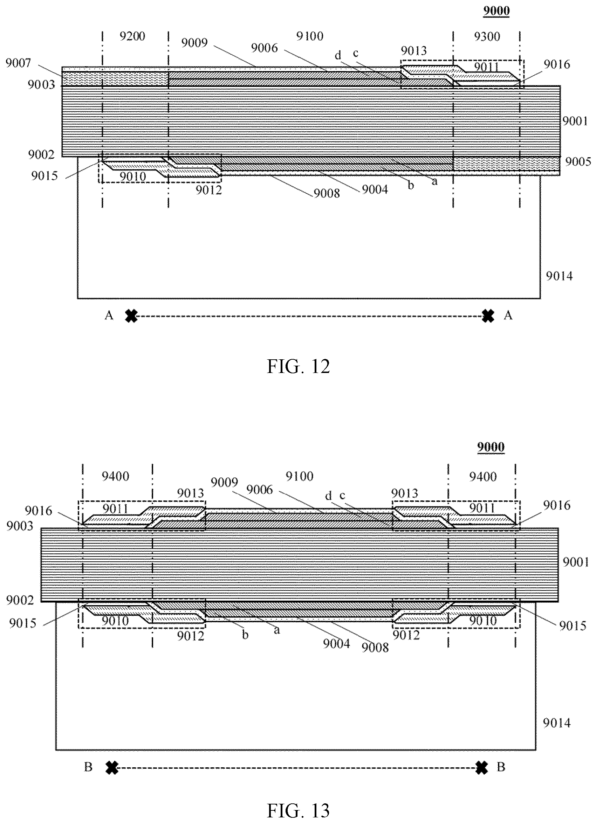

FIGS. 12 to 13 illustrate schematic structural views of a bulk acoustic wave resonance device 9000 according to an embodiment of the present disclosure;

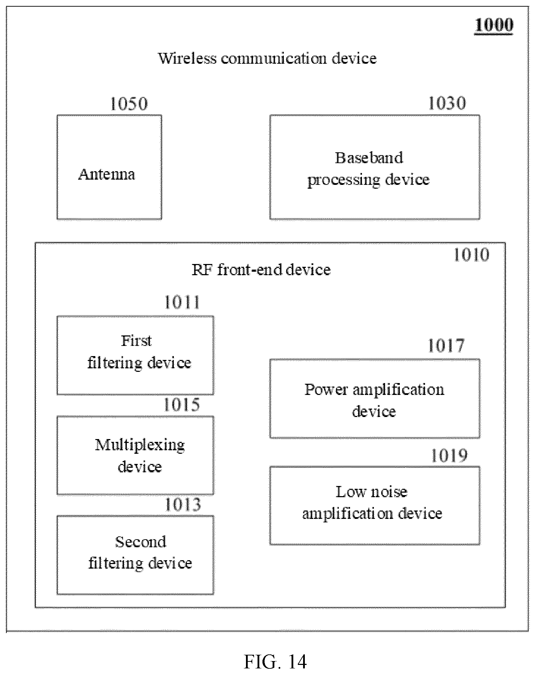

FIG. 14 illustrates a schematic structural view of a wireless communication device 1000;

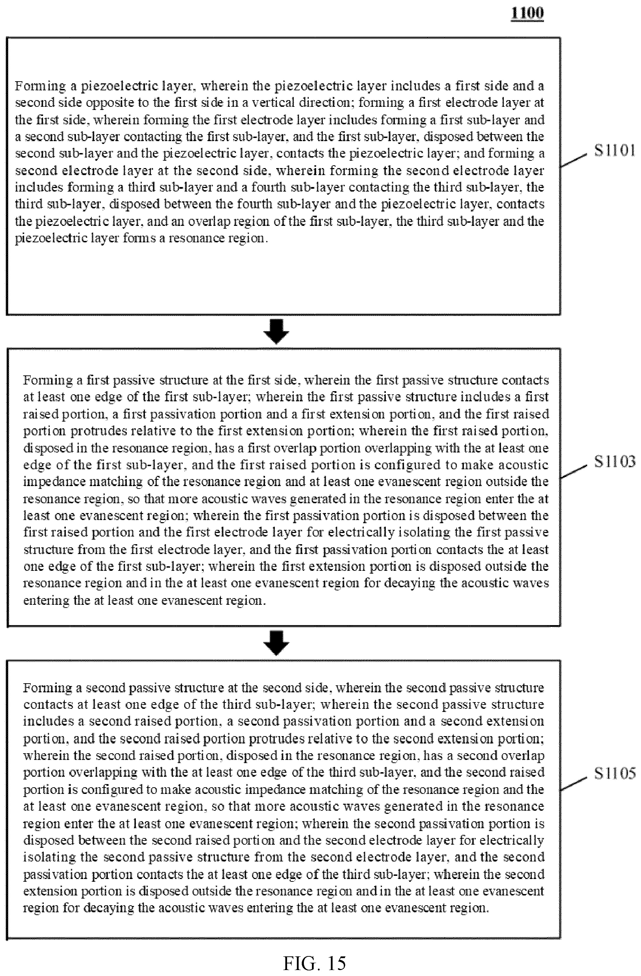

FIG. 15 illustrates a flowchart of a method 1100 for forming a bulk acoustic wave resonance device according to an embodiment of the present disclosure;

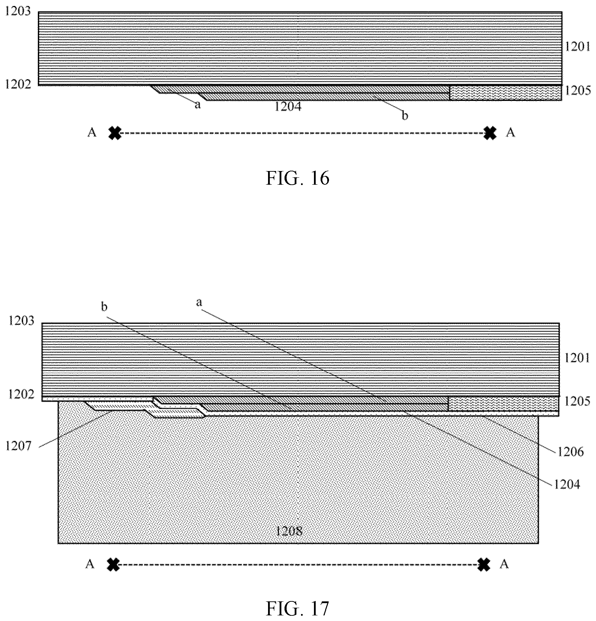

FIGS. 16 to 19 illustrate schematic structural views of section A during a method for forming a bulk acoustic wave resonance device 1200 according to an embodiment of the present disclosure; and

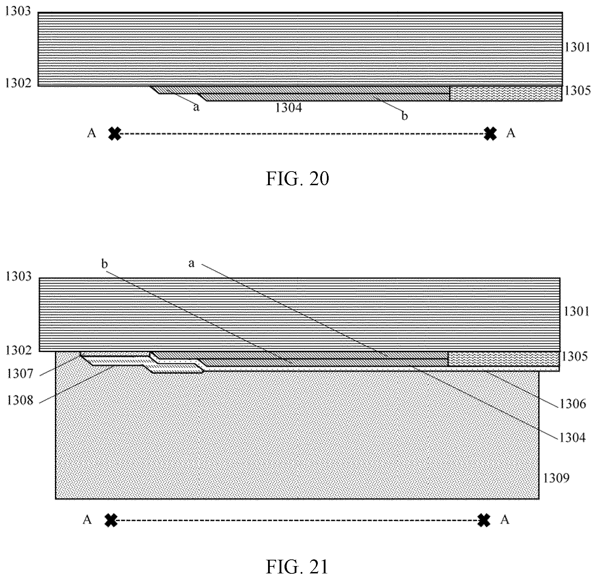

FIGS. 20 to 23 illustrate schematic structural views of section A during a method for forming a bulk acoustic wave resonance device 1300 according to an embodiment of the present disclosure.

### DETAILED DESCRIPTION

In order to make above-mentioned purpose, feature and advantage of the present disclosure more obvious and understandable, specific embodiments of the present invention will be described in detail below in conjunction with the accompanying drawings.

In following description, specific details are set forth in order to provide a thorough understanding of the present invention, but the present invention may be practiced otherwise than as specifically described herein, and therefore the present invention is not limited by the specific embodiments disclosed below. The present invention is defined by the appended claims.

As mentioned above, the acoustic waves generated in the resonance region propagate along directions parallel to surfaces of two electrode layers to a lateral edge of the piezoelectric layer, and resulting in exciting, at lateral edges, a lateral spurious mode, which leads to a spurious resonance and a reduction to Zₚ and corresponding Q value.

It has been found that the raised portions of the passive structures are disposed in the resonance region and have overlap portions overlapping with the electrode layers respectively, which can make acoustic impedance matching of the resonance region and the evanescent region outside the resonance region, so that more acoustic waves generated in the resonance region can propagate into the evanescent region. It has also been found that the thickness of the raised portion matches with the thickness of the sub-layer of the electrode layer disposed in the horizontal direction, that is, the thickness of the raised portion is approximate to the thickness of the sub-layer, which can improve a continuity of acoustic waves propagating from the resonance region into the evanescent region, so as to reduce a spurious resonance generated during the propagation process. It has also been found that the cutoff frequency of the evanescent region matches with (for example, equal to or less than) the cutoff frequency of the resonance region, which can decay the acoustic waves entering the evanescent region so as to suppress lateral spurious mode to improve Zₚ and corresponding Q value, and moreover the impact of the passive structures on Kt² is relatively small.

Therefore, an embodiment of the present invention provides a bulk acoustic wave resonance device. The bulk acoustic wave resonance device includes: a cavity; a first electrode layer, wherein at least one end of the first electrode layer is disposed above or in the cavity, and the first electrode layer includes a first sub-layer and a second sub-layer contacting the first sub-layer; a piezoelectric layer, wherein the piezoelectric layer includes a first side and a second side opposite to the first side in a vertical direction, wherein the cavity is disposed at the first side, the first electrode layer is disposed at the first side, and the first sub-layer, disposed between the second sub-layer and the piezoelectric layer, contacts the piezoelectric layer; a second electrode layer, disposed at the second side, wherein the second electrode layer includes a third sub-layer and a fourth sub-layer contacting the third sub-layer, the third sub-layer, disposed between the fourth sub-layer and the piezoelectric layer, contacts the piezoelectric layer, and an overlap region of the first sub-layer, the third sub-layer and the piezoelectric layer forms a resonance region; a first passive structure, disposed at the first side and contacting at least one edge of the first sub-layer; and a second passive structure, disposed at the second side and contacting at least one edge of the third sub-layer.

The first passive structure includes: a first raised portion, disposed in the resonance region and having a first overlap portion overlapping with the at least one edge of the first sub-layer, wherein the first raised portion is configured to make acoustic impedance matching of the resonance region and at least one evanescent region outside the resonance region, so that more acoustic waves generated in the resonance region enter the at least one evanescent region; a first passivation portion, disposed between the first raised portion and the first electrode layer for electrically isolating the first passive structure from the first electrode layer; and a first extension portion, disposed outside the resonance region and in the at least one evanescent region for decaying the acoustic waves entering the at least one evanescent region, wherein the first raised portion protrudes relative to the first extension portion.

The second passive structure includes: a second raised portion, disposed in the resonance region and having a second overlap portion overlapping with the at least one edge of the third sub-layer, wherein the second raised portion is configured to make acoustic impedance matching of the resonance region and the at least one evanescent region, so that more acoustic waves generated in the resonance region enter the at least one evanescent region; a second passivation portion, disposed between the second raised portion and the second electrode layer for electrically isolating the second passive structure from the second electrode layer; and a second extension portion, disposed outside the resonance region and in the at least one evanescent region for decaying the acoustic waves entering the at least one evanescent region, wherein the second raised portion protrudes relative to the second extension portion.

According to some embodiments, the at least one edge of the first sub-layer has a ramp-down shape corresponding to the first passive structure, and the at least one edge of the third sub-layer has a ramp-down shape corresponding to the second passive structure.

According to some embodiments, a dimension of the second sub-layer is smaller than a dimension of the first sub-layer, and a dimension of the fourth sub-layer is smaller than a dimension of the third sub-layer.

According to some embodiments, at least one edge of the second sub-layer is disposed at an inner side to at least one corresponding edge of the first sub-layer, and at least one edge of the fourth sub-layer is disposed at an inner side to at least one corresponding edge of the third sub-layer.

According to some embodiments, the at least one edge of the first sub-layer includes a first edge, and the at least one edge of the second sub-layer includes a second edge, wherein the first edge corresponds to the second edge in the vertical direction, and the second edge is disposed at an inner side to the first edge.

According to some embodiments, the at least one edge of the third sub-layer includes a third edge, and the at least one edge of the fourth sub-layer includes a fourth edge, wherein the third edge corresponds to the fourth edge in the vertical direction, and the fourth edge is disposed at an inner side to the third edge.

According to some embodiments, the first passive structure and the second passive structure surround the resonance region.

According to some embodiments, a thickness of the first passive structure is equal to or less than a thickness of the first electrode layer, and a thickness of the second passive structure is equal to or less than a thickness of the second electrode layer.

According to some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

According to some embodiments, the bulk acoustic wave resonance device further includes: a first electrode extension layer, disposed at the first side and coupled with the first electrode layer; and a second electrode extension layer, disposed at the second side and coupled with the second electrode layer.

According to some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

According to some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

According to some embodiments, a width of the first raised portion is an integer multiple of a half wavelength of the acoustic waves generated in the resonance region, and a width of the second raised portion is an integer multiple of the half wavelength of the acoustic waves generated in the resonance region.

According to some embodiments, the first raised portion is made of a material including a metal, the first extension portion is made of a material including a metal, the second raised portion is made of a material including a metal, and the second extension portion is made of a material including a metal.

According to some embodiments, the first sub-layer is disposed at one side of the first raised portion in the vertical direction, the second sub-layer is disposed at one side of the first raised portion in a horizontal direction, the third sub-layer is disposed at one side of the second raised portion in the vertical direction, and the fourth sub-layer is disposed at one side of the second raised portion in the horizontal direction.

According to some embodiments, the first overlap portion extends to at least one corresponding edge of the second sub-layer in a horizontal direction, and the second overlap portion extends to at least one corresponding edge of the fourth sub-layer in the horizontal direction.

According to some embodiments, a thickness of the first extension portion is less than a thickness of the first electrode layer, and a thickness of the second extension portion is less than a thickness of the second electrode layer.

According to some embodiments, the first extension portion includes a first sub-portion and a second sub-portion, the second sub-portion and the piezoelectric layer are disposed at two opposite sides of the first sub-portion, and a material of the first sub-portion is different from a material of the second sub-portion.

According to some embodiments, the second extension portion includes a third sub-portion and a fourth sub-portion, the fourth sub-portion and the piezoelectric layer are disposed at two opposite sides of the third sub-portion, and a material of the third sub-portion is different from a material of the fourth sub-portion.

According to some embodiments, the first passivation portion is made of a dielectric material, and the second passivation portion is made of a dielectric material.

According to some embodiments, the first passivation portion is further disposed between the piezoelectric layer and the first extension portion, and the second passivation portion is further disposed between the piezoelectric layer and the second extension portion.

According to some embodiments, a first gap is disposed between the first extension portion and the piezoelectric layer, and a second gap is disposed between the piezoelectric layer and the second extension portion.

It should be noted that the raised portions of the passive structures are disposed in the resonance region and have overlap portions overlapping with the electrode layers respectively, which can make acoustic impedance matching of the resonance region and the evanescent region outside the resonance region, so that more acoustic waves generated in the resonance region can propagate into the evanescent region. In addition, the thickness of the raised portion matches with the thickness of the sub-layer of the electrode layer disposed in the horizontal direction, that is, the thickness of the raised portion is approximate to the thickness of the sub-layer, which can improve a continuity of the acoustic waves propagating from the resonance region into the evanescent region, so as to reduce a spurious resonance generated during the propagation process. In addition, the cutoff frequency of the evanescent region matches with (for example, equal to or less than) the cutoff frequency of the resonance region, which can decay the acoustic waves entering the evanescent region so as to suppress lateral spurious mode to improve Zₚ and corresponding Q value, and moreover the impact of the passive structures on Kt² is relatively small.

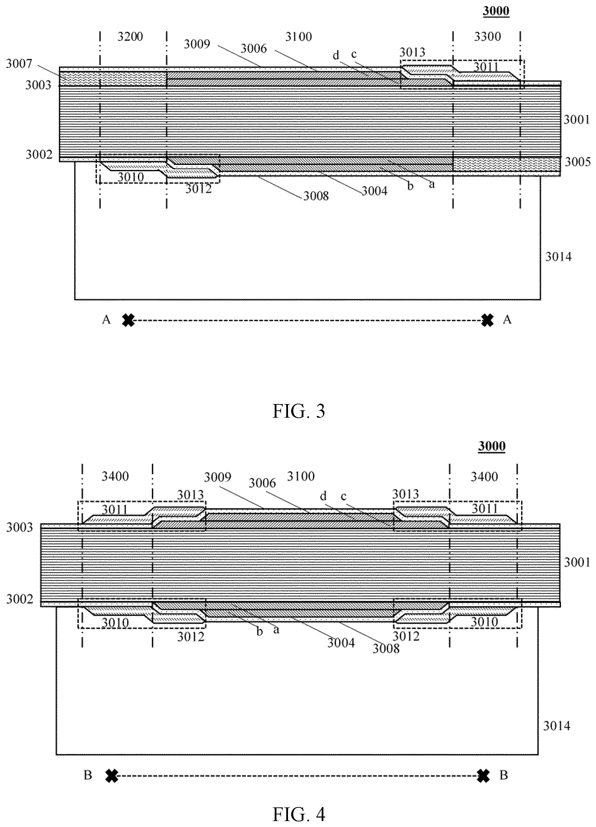

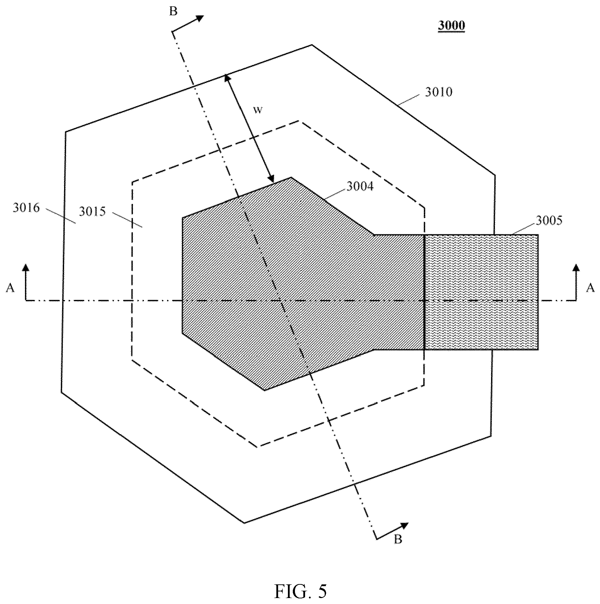

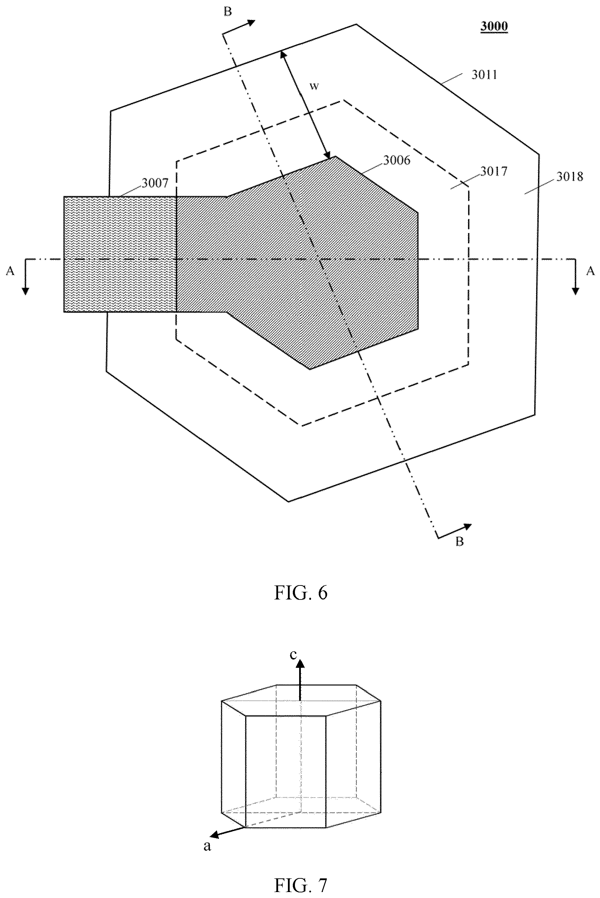

FIGS. 3 to 6 illustrate specific embodiments of a bulk acoustic wave resonance device of the present disclosure, but the present disclosure can also be implemented in other ways different from the specific embodiments described here, so the present disclosure is not limited by the specific embodiments disclosed below. FIG. 3 illustrates a schematic structure view of a first cross-section of the bulk acoustic wave resonance device, FIG. 4 illustrates a schematic structure view of a second cross-section of the bulk acoustic wave resonance device, FIG. 5 illustrates a schematic structure view of a first top side of a first electrode layer of the body acoustic wave resonance device relative to the first cross-section, and FIG. 6 illustrates a schematic structure view of a second top side of a second electrode layer of the body acoustic wave resonance device relative to the first cross-section.

FIG. 3 illustrates a schematic structure view of a cross-section A of a bulk acoustic wave resonance device 3000.

As shown in FIG. 3, the bulk acoustic wave resonance device 3000 includes a piezoelectric layer 3001, a first electrode layer 3004, a first electrode extension layer 3005, a second electrode layer 3006, a second electrode extension layer 3007, a first passivation layer 3008, a second passivation layer 3009, a first overlap layer 3010 and a second overlap layer 3011. The piezoelectric layer 3001 includes a first side 3002 and a second side 3003 opposite to the first side 3002 in a vertical direction. The first electrode layer 3004 is disposed at the first side 3002 and contacts the piezoelectric layer 3001. The first electrode layer 3004 includes a first sub-layer a and a second sub-layer b. The first sub-layer a contacts the piezoelectric layer 3001, and the second sub-layer b contacts the first sub-layer a. The first sub-layer a is disposed between the piezoelectric layer 3001 and the second sub-layer b. The first sub-layer a includes a first edge and a second edge opposite to the first edge in a horizontal direction, and the second sub-layer b includes a third edge and a fourth edge opposite to the third edge in the horizontal direction. The first edge has a ramp-down shape, and the third edge has a ramp-down shape. The third edge is disposed at an inner side to the first edge, the fourth edge is aligned with the second edge, and a dimension of the second sub-layer b is smaller than a dimension of the first sub-layer a. The first electrode extension layer 3005 is disposed at the first side 3002. The first electrode extension layer 3005 contacts the piezoelectric layer 3001 and is coupled with the second edge and the fourth edge. The second electrode layer 3006 is disposed at the second side 3003 and contacts the piezoelectric layer 3001. The second electrode layer 3006 includes a third sub-layer c and a fourth sub-layer d. The third sub-layer c contacts the piezoelectric layer 3001, and the fourth sub-layer d contacts the third sub-layer c. The third sub-layer c is disposed between the piezoelectric layer 3001 and the fourth sub-layer d. The third sub-layer c includes a fifth edge and a sixth edge opposite to the fifth edge in the horizontal direction, and the fourth sub-layer d includes a seventh edge and an eighth edge opposite to the seventh edge in the horizontal direction. The sixth edge has a ramp-down shape, and the eighth edge has a ramp-down shape. The eighth edge is disposed at an inner side to the sixth edge, the fifth edge is aligned with the seventh edge, and a dimension of the fourth sub-layer d is smaller than a dimension of the third sub-layer c. The second electrode extension layer 3007 is disposed at the second side 3003. The second electrode extension layer 3007 contacts the piezoelectric layer 3001 and is coupled with the fifth edge and the seventh edge. An overlap region of the first sub-layer a, the third sub-layer c and the piezoelectric layer 3001 forms a resonance region 3100. The first edge corresponds to the fifth edge and the seventh edge in the vertical direction, and the sixth edge corresponds to the fourth edge and the second edge in the vertical direction. The first electrode extension layer 3005 and the second electrode extension layer 3007 are disposed outside the resonance region 3100, and there is no overlap portion between the first electrode extension layer 3005 and the second electrode extension layer 3007. The first passivation layer 3008 is disposed at the first side 3002. One part of the first passivation layer 3008 in the resonance region 3100 covers the first electrode layer 3004, and the other part of the first passivation layer 3008 outside the resonance region 3100 covers the piezoelectric layer 3001 outside the first edge, and also covers the first electrode extension layer 3005 outside the second edge and the fourth edge. The second passivation layer 3009 is disposed at the second side 3003. One part of the second passivation layer 3009 in the resonance region 3100 covers the second electrode layer 3006, and the other part of the second passivation layer 3009 outside the resonance region 3100 covers the second electrode extension layer 3007 outside the fifth edge and seventh edge, and also covers the piezoelectric layer 3001 outside the sixth edge. The first overlap layer 3010 is disposed at the first side 3002 and contacts the first passivation layer 3008. The first overlap layer 3010 includes a first raised portion (not marked) and a first extension portion (not marked). The first raised portion protrudes relative to the first extension portion. The first raised portion is disposed in the resonance region 3100, and has a first overlap portion overlapping with the first edge. The first overlap portion extends to the third edge in the horizontal direction. The first raised portion and the first electrode layer 3004 are disposed at two opposite sides of the first passivation layer 3008. The first extension portion is disposed outside the resonance region 3100 and outside the first edge, and the first extension portion does not overlap with the first electrode layer 3004. The first extension portion and the piezoelectric layer 3001 are disposed at two opposite sides the first passivation layer 3008. The second overlap layer 3011 is disposed at the second side 3003 and contacts the second passivation layer 3009. The second overlap layer 3011 includes a second raised portion (not marked) and a second extension portion (not marked). The second raised portion protrudes relative to the second extension portion. The second raised portion is disposed in the resonance region 3100, and has a second overlap portion overlapping with the sixth edge. The second overlap portion extends to the eighth edge. The second raised portion and the second electrode layer 3006 are disposed at two opposite sides of the second passivation layer 3009. The second extension portion is disposed outside the resonance region 3100 and outside the sixth edge, and the second extension portion does not overlap with the second electrode layer 3006. The second extension portion and the piezoelectric layer 3001 are disposed at two opposite sides of the second passivation layer 3009.

In some embodiments, the material of the piezoelectric layer 3001 includes, but is not limited to, one of the following: aluminum nitride, aluminum nitride alloy, gallium nitride, zinc oxide, lithium tantalate, lithium niobate, lead zirconate titanate (PZT), and lead magnesium niobate-lead titanate.

In some embodiments, the piezoelectric layer 3001 is a flat layer. The piezoelectric layer 3001 includes a plurality of crystal grains. The plurality of crystal grains include a first crystal grain and a second crystal grain, and the first crystal grain and the second crystal grain are any two crystal grains of the plurality of crystal grains. It should be understood by those skilled in the art that crystal orientation and crystal plane of a crystal grain can be represented based on a coordinate system. As shown in FIG. 7, a hexagonal crystal grain, such as an aluminum nitride crystal grain, may be represented by an ac stereoscopic coordinate system (including a-axis and c-axis). As shown in FIG. 8, the crystal grains of (i) orthorhombic system (a ≠ b ≠ c), (ii) tetragonal system (a = b ≠c), (iii) cubic system (a = b = c), etc., may be represented by an xyz stereoscopic coordinate system (including x-axis, y-axis and z-axis). In addition to the two embodiments described above, crystal grains may also be represented based on other coordinate systems known to those skilled in the art, and therefore the present disclosure is not limited by the two embodiments described above.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction ranges from 0 degree to 5 degrees, and the first direction being opposite to the second direction means that the included angle between the vector along the first direction and the vector along the second direction ranges from 175 degrees to 180 degrees.

In some embodiments, the first stereoscopic coordinate system is an ac stereoscopic coordinate system, wherein the first coordinate axis is a first c-axis and the third coordinate axis is a first a-axis. The second stereoscopic coordinate system is an ac stereoscopic coordinate system, wherein the second coordinate axis is a second c-axis, and the fourth coordinate axis is a second a-axis. The first c-axis and the second c-axis have the same or opposite orientation.

In some embodiments, the first stereoscopic coordinate system further includes a fifth coordinate axis along a fifth direction and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction ranges from 0 degree to 5 degrees, and the third direction being opposite to the fourth direction means that the included angle between the vector along the third direction and the vector along the fourth direction ranges from 175 degrees to 180 degrees.

In some embodiments, the first stereoscopic coordinate system is an xyz stereoscopic coordinate system, wherein the first coordinate axis is a first z-axis, the third coordinate axis is a first y-axis, and the fifth coordinate axis is a first x-axis. The second stereoscopic coordinate system is an xyz stereoscopic coordinate system, wherein the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientation, and the first y-axis and the second y-axis have opposite orientation. In some embodiments, the first z-axis and the second z-axis have the same orientation, and the first y-axis and the second y-axis have opposite orientation. In some embodiments, the first z-axis and the second z-axis have opposite orientation, and the first y-axis and the second y-axis have the same orientation.

In some embodiments, the piezoelectric layer 3001 includes a plurality of crystal grains and a crystal composed of the plurality of crystal grains has a full width at half maximum of rocking curve less than 2.5 degrees. It should be noted that the rocking curve describes a magnitude of angular divergence of a particular crystal plane (a crystal plane determined by a diffraction angle) in a sample, which is represented by a plane coordinate system, wherein an abscissa represents an angle between the crystal plane and a sample plane, and an ordinate represents a diffraction intensity of the crystal plane at a certain angle. The rocking curve is used to represent quality of the crystal, and the smaller the full width at half maximum is, the better the quality of the crystal is. In addition, the Full Width at Half Maximum (FWHM) refers to an interval between two points whose function values are equal to a half of a peak value of the function.

In some embodiments, the material of the first electrode layer 3004 includes, but is not limited to, at least one of the following: molybdenum, ruthenium, tungsten, platinum, iridium, aluminum and beryllium, and the material of the first electrode extension layer 3005 includes, but is not limited to, at least one of the following: molybdenum, ruthenium, tungsten, platinum, iridium, aluminum, beryllium, copper and gold. In some embodiments, the material of the first electrode layer 3004 may be the same as that of the first electrode extension layer 3005. In some embodiments, the material of the first sub-layer a is the same as that of the second sub-layer b. In some embodiments, a thickness of the first sub-layer a is greater than 1 nm.

In some embodiments, the material of the second electrode layer 3006 includes, but is not limited to, at least one of the following: molybdenum, ruthenium, tungsten, platinum, iridium, aluminum, beryllium, copper and gold, and the material of the second electrode extension layer 3007 includes, but is not limited to, at least one of the following: molybdenum, ruthenium, tungsten, platinum, iridium, aluminum, beryllium, copper and gold. In some embodiments, the material of the second electrode layer 3006 may be the same as that of the second electrode extension layer 3007. In some embodiments, the material of the third sub-layer c is the same as that of the fourth sub-layer d. In some embodiments, a thickness of the third sub-layer c is greater than 1 nm.

In some embodiments, the material of the electrode layer may be different from that of the electrode extension layer.

In some embodiments, the material of the first passivation layer 3008 includes, but is not limited to, one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the second passivation layer 3009 includes, but is not limited to one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the first passivation layer 3008 may be the same as that of the second passivation layer 3009. In other embodiments, the material of the first passivation layer (e.g., the first passivation layer 3008) may be different from that of the second passivation layer (e.g., the second passivation layer 3009).

In some embodiments, the material of the first overlap layer 3010 includes, but is not limited to, at least one of the following: molybdenum, ruthenium, tungsten, platinum, iridium, aluminum, beryllium, copper and gold. In some embodiments, the material of the first overlap layer 3010 may be the same as that of the first electrode layer 3004.

In some embodiments, the material of the second overlap layer 3011 includes, but is not limited to, at least one of the following: molybdenum, ruthenium, tungsten, platinum, iridium, aluminum, beryllium, copper and gold. In some embodiments, the material of the second overlap layer 3011 may be the same as that of the second electrode layer 3006.

In other embodiments, the material of the overlap layer may be different from that of the electrode layer, for example, the material of the overlap layer is tungsten or platinum, and the material of the electrode layer is molybdenum.

In some embodiments, the overlap layer includes a first overlap sub-layer and a second overlap sub-layer. The first overlap sub-layer contacts the passivation layer, the second overlap sub-layer contacts the first overlap sub-layer, and the second overlap sub-layer and the passivation layer are disposed at two opposite sides of the first overlap sub-layer. The material of the first overlap sub-layer may be different from that of the second overlap sub-layer, for example, the material of the first overlap sub-layer is molybdenum, and the material of the second overlap sub-layer is platinum or tungsten.

In some embodiments, the bulk acoustic wave resonance device 3000 further includes a first passive structure 3012 and a second passive structure 3013. The first passive structure 3012 is disposed at the first side 3002 and contacts the first edge of the first sub-layer a, the third edge of the second sub-layer b and the piezoelectric layer 3001 outside the first edge. The first passive structure 3012 includes the first overlap layer 3010 and a first passivation portion (not marked) that is a part of the first passivation layer 3008 overlapping with the first overlap layer 3010. The second passive structure 3013 is disposed at the second side 3003 and contacts the sixth edge of the third sub-layer c, the eighth edge of the fourth sub-layer d and the piezoelectric layer 3001 outside the sixth edge. The second passive structure 3013 includes the second overlap layer 3011 and a second passivation portion (not marked) that is a part of the second passivation layer 3009 overlapping with the second overlap layer 3011. It should be noted that the passivation portions may include a dielectric material, which can electrically isolate the overlap layers from the electrode layers, so that the electrode layers and the overlap layers are not electrically coupled, thus the overlap layers are passive, and thus a combination structure of the passivation portion and the overlap layer is also passive.

In some embodiments, a first thickness of the first passive structure 3012 (i.e., a sum of a thickness of the first overlap layer 3010 and a thickness of the first passivation layer 3008) is less than a thickness of the first electrode layer 3004; a second thickness of the second passive structure 3013 (i.e., a sum of a thickness of the second overlap layer 3011 and a thickness of the second passivation layer 3009) is less than a thickness of the second electrode layer 3006; and the first thickness is equal to or approximately equal to the second thickness.

In some embodiments, a first width of the first raised portion matches with a wavelength of major-mode transverse acoustic waves generated in the resonance region 3100, such as Rayleigh-Lamb 1st order mode or 1st order Thickness Extension mode (for example, the first width is an integer multiple of the half wavelength). A second width of the second raised portion matches with the wavelength of the major-mode transverse acoustic waves generated in the resonance region 3100 (for example, the second width is equal to an integer multiple of the half wavelength), and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, the first sub-layer a is disposed at one side of the first raised portion in the vertical direction, the second sub-layer b is disposed at one side of the first raised portion in the horizontal direction, the third sub-layer is disposed at one side of the second raised portion in the vertical direction, and the fourth sub-layer is disposed at one side of the second raised portion in the horizontal direction.

In some embodiments, a third thickness of the first extension portion (i.e., the thickness of the first overlap layer 3010 outside the resonance region 3100) is less than the thickness of the first electrode layer 3004, a fourth thickness of the second extension portion (i.e., the thickness of the second overlap layer 3011 outside the resonance region 3100) is less than the thickness of the second electrode layer 3006, and the third thickness is equal to or approximately equal to the fourth thickness.

In some embodiments, an overlap region of the first extension portion, the second electrode extension layer 3007 and the piezoelectric layer 3001 forms an evanescent region 3200, and an overlap region of the second extension portion, the first electrode extension layer 3005 and the piezoelectric layer 3001 forms an evanescent region 3300. A second cutoff frequency of the evanescent region 3200 matches with (for example, equal to or less than) a first cutoff frequency of the resonance region 3100, a third cutoff frequency of the evanescent region 3300 matches with (for example, equal to or less than) the first cutoff frequency of the resonance region 3100, and the second cutoff frequency is equal to or approximately equal to the third cutoff frequency.

It should be noted that the cutoff frequency of the evanescent region matches with (for example, equal to or less than) the cutoff frequency of the resonance region, which results in the acoustic waves entering the evanescent region are in the evanescent mode, that is, the wave number in the evanescent region only includes an imaginary part, resulting in an exponential decay of the acoustic waves. In order to more clearly illustrate the advantages of the embodiments of the present disclosure, as shown in FIG. 9, which illustrates multiple dispersion curves 600. A horizontal axis of the dispersion curve coordinate system represents a wave number, a vertical axis represents a frequency, and an origin of the coordinate system represents a zero wave number. A left side axis to the origin indicates that the wave number only contains an imaginary part, and a right side axis to the origin indicates that the wave number only contains a real part. As shown in FIG. 9, a first dispersion curve 601 represents a dispersion relationship of the resonance region, and an intersection of the first dispersion curve 601 and the vertical axis represents a first cutoff frequency 602 of the resonance region. A second dispersion curve 603 represents a dispersion relationship of the evanescent region, an intersection of the second dispersion curve 603 and the vertical axis represents a second cutoff frequency 604 of the evanescent region, and the second cutoff frequency 604 is smaller than the first cutoff frequency 602. Referring to FIG. 9, at a parallel resonance frequency fp, the wave number of the first dispersion curve 601 only includes a real part, and the wave number of the second dispersion curve 603 only includes an imaginary part. Therefore, the acoustic waves propagate from the resonance region into the evanescent region and the evanescent mode is excited, so that the acoustic waves have an exponential decay. Specifically, an expression for an acoustic wave displacement includes exp (-jkx), where a wave number k only includes an imaginary part.

FIG. 10 illustrates two parallel impedance curves, where a horizontal axis represents a relative frequency and a vertical axis represents a relative parallel impedance value. The relative parallel impedance value represents a ratio of an absolute parallel impedance value to a specific parallel impedance value. For example, if the absolute parallel impedance value is 300 ohms and the specific parallel impedance value is 500 ohms, the relative parallel impedance value is 0.6 (300/500). Referring to FIG. 10, a first parallel impedance curve 701 represents a relative parallel impedance curve of a bulk acoustic wave resonance device without a passive structure, and a second parallel impedance curve 703 represents a relative parallel impedance curve of a bulk acoustic wave resonance device with a passive structure. As shown in FIG. 10, for the parallel resonance frequency fp, a corresponding value on the second parallel impedance curve 703 is greater than a corresponding value on the first parallel impedance curve 701. It should be noted that the passive structures can decay the transverse acoustic waves generated in the resonance region, so as to suppress lateral spurious mode to improve Zₚ and corresponding Q value. In addition, the passive structures are not electrically coupled with the electrode layers, thus the impact of the passive structures on Kt² is relatively small.

FIG. 11 illustrates multiple parallel impedance curves 800, where a horizontal axis represents a relative frequency and a vertical axis represents a relative parallel impedance value. Referring to FIG. 11, a third parallel impedance curve 801 corresponds to the structure 1, a fourth parallel impedance curve 803 corresponds to the structure 2, and a fifth parallel impedance curve 805 corresponds to the structure 3. A first raised portion in the structure 1 is disposed on an electrode layer, and a second raised portion and a third raised portion in the structure 2 and the structure 3 respectively are embedded into the electrode layer. A thickness of the second raised portion is approximate to the thickness of a third raised portion, the thickness of the third raised portion is relatively approximate to a thickness of a sub-layer of the electrode layer disposed in the horizontal direction, and the thickness of the second raised portion is significantly different from the thickness of the sub-layer of the electrode layer disposed in the horizontal direction. At a parallel resonance frequency fp, a corresponding value on the fifth parallel impedance curve 805 is greater than a corresponding value on the fourth parallel impedance curve 803, and a corresponding value on the fourth parallel impedance curve 803 is greater than a corresponding value on the third parallel impedance curve 801. It should be noted that the thickness of the raised portion matches with the thickness of the sub-layer (i.e., the second sub-layer b and the fourth sub-layer d) of the electrode layer disposed in the horizontal direction, that is, the thickness of the raised portion is approximate to the thickness of the sub-layer, which can improve the continuity of the acoustic waves propagating from the resonance region into the evanescent region, so as to reduce a spurious resonance generated during the propagation process to further improve the parallel impedance Zₚ and corresponding Q value.

In some embodiments, the bulk acoustic wave resonance device 3000 further includes a cavity 3014. The first electrode layer 3004 is disposed in the cavity 3014, one end of the first electrode extension layer 3005 is disposed in the cavity 3014, and the first passive structure 3012 is disposed in the cavity 3014. In other embodiments, a lower electrode layer (i.e., the first electrode layer 3004) may be disposed above the cavity and cover the cavity. The passive structure corresponding to the lower electrode layer may be disposed outside the cavity.

FIG. 4 illustrates a schematic structure view of a cross-section B of the bulk acoustic wave resonance device 3000 according to an embodiment of the present disclosure.

As shown in FIG. 4, the bulk acoustic wave resonance device 3000 includes the piezoelectric layer 3001, the first electrode layer 3004, the second electrode layer 3006, the first passivation layer 3008, the second passivation layer 3009, the first overlap layer 3010 and the second overlap layer 3011. The piezoelectric layer 3001 includes the first side 3002 and the second side 3003. The first electrode layer 3004 is disposed at the first side 3002 and contacts the piezoelectric layer 3001. The first electrode layer 3004 includes the first sub-layer a and the second sub-layer b. The first sub-layer a contacts the piezoelectric layer 3001, and the second sub-layer b contacts the first sub-layer a. The first sub-layer a is disposed between the piezoelectric layer 3001 and the second sub-layer b. The first sub-layer a also includes a ninth edge and a tenth edge opposite to the ninth edge in the horizontal direction. The ninth edge has a ramp-down shape, and the tenth edge has a ramp-down shape. The second sub-layer b also includes an eleventh edge and a twelfth edge opposite to the eleventh edge in the horizontal direction. The eleventh edge has a ramp-down shape, and the twelfth edge has a ramp-down shape. The eleventh edge is disposed at an inner side to the ninth edge, the twelfth edge is disposed at an inner side to the tenth edge, and the dimension of the second sub-layer b is smaller than the dimension of the first sub-layer a. The second electrode layer 3006 is disposed at the second side 3003 and contacts the piezoelectric layer 3001. The second electrode layer 3006 includes the third sub-layer c and the fourth sub-layer d. The third sub-layer c contacts the piezoelectric layer 3001, and the fourth sub-layer d contacts the third sub-layer c. The third sub-layer c is disposed between the piezoelectric layer 3001 and the fourth sub-layer d. The third sub-layer c includes a thirteenth edge and a fourteenth edge opposite to the thirteenth edge in the horizontal direction. The thirteenth edge has a ramp-down shape, and the fourteenth edge has a ramp-down shape. The fourth sub-layer d includes a fifteenth edge and a sixteenth edge opposite to the fifteenth edge in the horizontal direction. The fifteenth edge has a ramp-down shape, and the sixteenth edge has a ramp-down shape. The fifteenth edge is disposed at an inner side to the thirteenth edge, the sixteenth edge is disposed at an inner side to the fourteenth edge, and the dimension of the fourth sub-layer d is smaller than the dimension of the third sub-layer c. **In** the resonance region 3100, the ninth edge corresponds to the thirteenth edge in the vertical direction, the tenth edge corresponds to the fourteenth edge in the vertical direction, the eleventh edge corresponds to the fifteenth edge in the vertical direction, and the twelfth edge corresponds to the sixteenth edge in the vertical direction. The first passivation layer 3008 is disposed at the first side 3002. The part of the first passivation layer 3008 in the resonance region 3100 covers the first electrode layer 3004, and the other part of the first passivation layer 3008 outside the resonance region 3100 covers the piezoelectric layer 3001 outside the ninth edge, and also covers the piezoelectric layer 3001 outside the tenth edge. The second passivation layer 3009 is disposed at the second side 3003. The part of the second passivation layer 3009 in the resonance region 3100 covers the second electrode layer 3006, and the other part of the second passivation layer 3009 outside the resonance region 3100 covers the piezoelectric layer 3001 outside the thirteenth edge, and also covers the piezoelectric layer 3001 outside the fourteenth edge. The first overlap layer 3010 is disposed at the first side 3002 and contacts the first passivation layer 3008. The first overlap layer 3010 includes the first raised portion and the first extension portion, and the first raised portion protrudes relative to the first extension portion. The first raised portion is disposed in the resonance region 3100, and has a third overlap portion overlapping with the ninth edge and a fourth overlap portion overlapping with the tenth edge. The third overlap portion extends to the eleventh edge in the horizontal direction, and the fourth overlap portion extends to the twelfth edge in the horizontal direction. The first raised portion and the first electrode layer 3004 are disposed at two opposite sides of the first passivation layer 3008. The first extension portion is disposed outside the resonance region 3100 and outside the ninth edge and the tenth edge, and does not overlap with the first electrode layer 3004. The first extension portion and the piezoelectric layer 3001 are disposed at two opposite sides of the first passivation layer 3008. The second overlap layer 3011 is disposed at the second side 3003 and contacts the second passivation layer 3009. The second overlap layer 3011 includes the second raised portion and the second extension portion, and the second raised portion protrudes relative to the second extension portion. The second raised portion is disposed in the resonance region 3100, and has a fifth overlap portion overlapping with the thirteenth edge and a sixth overlap portion overlapping with the fourteenth edge. The fifth overlap portion extends to the fifteenth edge in the horizontal direction, and the sixth overlap portion extends to the sixteenth edge in the horizontal direction. The second raised portion and the second electrode layer 3006 are disposed at two opposite sides of the second passivation layer 3009. The second extension portion is disposed outside the resonance region 3100 and outside the thirteenth edge and the fourteenth edge, and does not overlap with the second electrode layer 3006. The second extension portion and the piezoelectric layer 3001 are disposed at two opposite sides of the second passivation layer 3009.

In some embodiments, an overlap region of the first extension portion, the second extension portion and the piezoelectric layer 3001 forms an evanescent region 3400. A fourth cutoff frequency of the evanescent region 3400 matches with (for example, equal to or less than) the first cutoff frequency of the resonance region 3100.

FIG. 5 illustrates a schematic view of a first top side of the first electrode layer 3004 of the bulk acoustic wave resonance device 3000 relative to the cross-section A according to an embodiment of the present disclosure.

As shown in FIG. 5, the bulk acoustic wave resonance device 3000 includes the first electrode layer 3004 (indicated by a dashed line). The first electrode layer 3004 is hexagonal, including the first edge, the second edge, the ninth edge, the tenth edge, a seventeenth edge and an eighteenth edge. The first electrode extension layer 3005 is coupled with the second edge. The first overlap layer 3010 overlaps with a plurality of edges of the first electrode layer 3004 and is adjacent to the first electrode extension layer 3005. The first overlap layer 3010 includes a first raised portion 3015 and a first extension portion 3016. The first raised portion 3015 is disposed at an inner side to the edges of the first electrode layer 3004, and overlaps with the ninth edge, the seventeenth edge, the first edge, the tenth edge and the eighteenth edge. The second extension portion 3005 is disposed at an outer side to the ninth edge, the seventeenth edge, the first edge, the tenth edge and the eighteenth edge, and does not overlap with the first electrode layer 3004.

In some embodiments, a width w of the first overlap layer 3010 corresponding to each edge is the same. Thus, a width of the first raised portion 3015 corresponding to each edge is the same, and a width of the first extension portion 3016 corresponding to each edge is the same.

In some embodiments, the first passive structure 3012 includes the first overlap layer 3010 adjacent to the first electrode extension layer 3005. In some embodiments, the first passive structure 3012 includes the first raised portion 3015. The first raised portion 3015 overlaps with the ninth edge, the seventeenth edge, the first edge, the tenth edge and the eighteenth edge. In some embodiments, the first passive structure 3012 also includes the first extension portion 3016. The first extension portion 3016 is disposed at the outer side to the ninth edge, the seventeenth edge, the first edge, the tenth edge and the eighteenth edge, and does not overlap with the first electrode layer 3004.

In some embodiments, a width w of the first passive structure 3012 corresponding to each edge is the same.

FIG. 6 illustrates a schematic structure view of a second top side of the second electrode layer 3006 of the body acoustic wave resonance device 300 relative to the cross-section A.

As shown in FIG. 6, the bulk acoustic wave resonance device 3000 includes the second electrode layer 3006 (indicated by a dashed line). The second electrode layer 3006 is hexagonal, including the fifth edge, the sixth edge, the thirteenth edge, the fourteenth edge, a nineteenth edge and a twentieth edge. The second electrode extension layer 3007 is coupled with the fifth edge. The second overlap layer 3011 overlaps with a plurality of edges of the second electrode layer 3006 and is adjacent to the second electrode extension layer 3007. The second overlap layer 3011 includes the second raised portion 3017 and the second extension portion 3018. The second raised portion 3017 is disposed at an inner side to the edges of the second electrode layer 3006, and overlaps with the thirteenth edge, the nineteenth edge, the sixth edge, the fourteenth edge and the twentieth edge. The second extension portion 3018 is disposed at an outer side to the thirteenth edge, the nineteenth edge, the sixth edge, the fourteenth edge and the twentieth edge, and does not overlap with the second electrode layer 3006.

In some embodiments, a width w of the second overlap layer 3011 corresponding to each edge is the same. Thus, a width of the second raised portion 3017 corresponding to each edge is the same, and a width of the second extension portion 3018 corresponding to each edge is the same.

In some embodiments, the second passive structure 3013 includes the second overlap layer 3011 adjacent to the second electrode extension layer 3007. In some embodiments, the second passive structure 3013 includes the second raised portion 3017. The second raised portion 3017 overlaps with the thirteenth edge, the nineteenth edge, the sixth edge, the fourteenth edge and the twentieth edge. In some embodiments, the second passive structure 3013 further includes the second extension portion 3018. The second extension portion 3018 is disposed at the outer side to the thirteenth edge, the nineteenth edge, the sixth edge, the fourteenth edge and the twentieth edge, and does not overlap with the second electrode layer 3006.

In some embodiments, a width w of the second passive structure 3013 corresponding to each edge is the same.

In some embodiments, the first passive structure 3012 and the second passive structure 3013 surround the first electrode layer 3004 and the second electrode layer 3006 respectively, that is, surround the resonance region 3100.

It should be noted that in some embodiments, a hexagonal top surface of the electrode layer is a specific embodiment. Therefore, the present disclosure is not limited by the disclosed specific embodiments below, and the top surface of the electrode layer can also be other polygons (such as pentagons, heptagons), ellipses, etc.

In other embodiments, the bulk acoustic wave resonance device includes a plurality of electrode extension layers coupled with a plurality of edges of the electrode layer respectively. The passive structure corresponding to the electrode layer is adjacent to the plurality of electrode extension layers, and overlaps with other edges other than the plurality of edges. The passive structure also includes a passive extension portion disposed outside the other edges.

In some embodiments, the bulk acoustic wave resonance device includes three or more passive structures, and the three or more passive structures surround the resonance region of the bulk acoustic wave resonance device.

FIGS. 12 and 13 illustrate a specific embodiment of a body acoustic wave resonance device of the present disclosure, but the present disclosure can also be implemented in other ways different from the specific embodiments described herein, so the present disclosure is not limited by the specific embodiments disclosed below. FIG. 12 illustrates a schematic structure view of a first cross-section of the body acoustic wave resonance device, and FIG. 13 illustrates a schematic structure view of a second cross-sectional of the body acoustic wave resonance device.

FIG. 12 illustrates a schematic structure view of a cross-section A of a body acoustic wave resonance device 9000.

As shown in FIG. 12, the bulk acoustic wave resonance device 9000 includes a piezoelectric layer 9001, a first electrode layer 9004, a first electrode extension layer 9005, a second electrode layer 9006, a second electrode extension layer 9007, a first passivation layer 9008, a second passivation layer 9009, a first overlap layer 9010 and a second overlap layer 9011. The piezoelectric layer 9001 includes a first side 9002 and a second side 9003 opposite to the first side 9002 in a vertical direction. The first electrode layer 9004 is disposed at the first side 9002 and contacts the piezoelectric layer 9001. The first electrode layer 9004 includes a first sub-layer a and a second sub-layer b. The first sub-layer a contacts the piezoelectric layer 9001, and the second sub-layer b contacts the first sub-layer a. The first sub-layer a is disposed between the piezoelectric layer 9001 and the second sub-layer b. The first sub-layer a includes a first edge and a second edge opposite to the first edge in a horizontal direction, and the second sub-layer b includes a third edge and a fourth edge opposite to the third edge in the horizontal direction. The first edge has a ramp-down shape, and the third edge has a ramp-down shape. The third edge is disposed at an inner side to the first edge, the fourth edge is aligned with the second edge, and a dimension of the second sub-layer b is smaller than a dimension of the first sub-layer a. The first electrode extension layer 9005 is disposed at the first side 9002. The first electrode extension layer 9005 contacts the piezoelectric layer 9001 and is coupled with the second edge and the fourth edge. The second electrode layer 9006 is disposed at the second side 9003 and contacts the piezoelectric layer 9001. The second electrode layer 9006 includes a third sub-layer c and a fourth sub-layer d. The third sub-layer c contacts the piezoelectric layer 9001, and the fourth sub-layer d contacts the third sub-layer c. The third sub-layer c is disposed between the piezoelectric layer 9001 and the fourth sub-layer d. The third sub-layer c includes a fifth edge and a sixth edge opposite to the fifth edge in the horizontal direction, and the fourth sub-layer d includes a seventh edge and an eighth edge opposite to the seventh edge in the horizontal direction. The sixth edge has a ramp-down shape, and the eighth edge has a ramp-down shape. The eighth edge is disposed at an inner side to the sixth edge, the fifth edge is aligned with the seventh edge, and a dimension of the fourth sub-layer d is smaller than a dimension of the third sub-layer c. The second electrode extension layer 9007 is disposed at the second side 9003. The second electrode extension layer 9007 contacts the piezoelectric layer 9001 and is coupled with the fifth edge and the seventh edge. An overlap region of the first sub-layer a, the third sub-layer c and the piezoelectric layer 9001 forms a resonance region 9100. The first edge corresponds to the fifth edge and the seventh edge in the vertical direction, and the sixth edge corresponds to the fourth edge and the second edge in the vertical direction. The first electrode extension layer 9005 and the second electrode extension layer 9007 are disposed outside the resonance region 9100, and there is no overlap portion between the first electrode extension layer 9005 and the second electrode extension layer 9007. The first passivation layer 9008 is disposed at the first side 9002. One part of the first passivation layer 9008 in the resonance region 9100 covers the first electrode layer 9004, and the other part of the first passivation layer 9008 outside the resonance region 9100 covers the first electrode extension layer 9005 outside the second edge and the fourth edge. The second passivation layer 9009 is disposed at the second side 9003. One part of the second passivation layer 9009 in the resonance region 9100 covers the second electrode layer 9006, and the other part of the second passivation layer 9009 outside the resonance region 9100 covers the second electrode extension layer 9007 outside the fifth edge and the seventh edge. The first overlap layer 9010 is disposed at the first side 9002 and contacts the first passivation layer 9008. The first overlap layer 9010 includes a first raised portion (not marked) and a first extension portion (not marked). The first raised portion protrudes relative to the first extension portion. The first raised portion is disposed in the resonance region 9100, and has a first overlap portion overlapping with the first edge. The first overlap portion extends to the third edge in the horizontal direction. The first raised portion and the first electrode layer 9004 are disposed at two opposite sides of the first passivation layer 9008. The first extension portion is disposed outside the resonance region 9100 and outside the first edge, and the first extension portion does not overlap with the first electrode layer 9004. A first gap 9015 is between the first extension portion and the piezoelectric layer 9001. The second overlap layer 9011 is disposed at the second side 9003 and contacts the second passivation layer 9009. The second overlap layer 9011 includes a second raised portion (not marked) and a second extension portion (not marked). The second raised portion protrudes relative to the second extension portion. The second raised portion is disposed in the resonance region 9100, and has a second overlap portion overlapping with the sixth edge and extending to the eighth edge in the horizontal direction. The second raised portion and the second electrode layer 9006 are disposed at two opposite sides of the second passivation layer 9009. The second extension portion is disposed outside the resonance region 9100 and outside the sixth edge, and the second extension portion does not overlap with the second electrode layer 9006. A second gap 9016 is between the second extension portion and the piezoelectric layer 9001.

In some embodiments, the material of the piezoelectric layer 9001 includes, but is not limited to, one of the following: aluminum nitride, aluminum nitride alloy, gallium nitride, zinc oxide, lithium tantalate, lithium niobate, lead zirconate titanate and lead magnesium niobate-lead titanate.

In some embodiments, the piezoelectric layer 9001 is a flat layer. The piezoelectric layer 9001 includes a plurality of crystal grains. The plurality of crystal grains include a first crystal grain and a second crystal grain, and the first crystal grain and the second crystal grain are any two crystal grains of the plurality of crystal grains. It should be understood by those skilled in the art that crystal orientation and crystal plane of a crystal grain can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction ranges from 0 degree to 5 degrees, and the first direction being opposite to the second direction means that the included angle between the vector along the first direction and the vector along the second direction ranges from 175 degrees to 180 degrees.

In some embodiments, the first stereoscopic coordinate system is an ac stereoscopic coordinate system, wherein the first coordinate axis is a first c-axis and the third coordinate axis is a first a-axis. The second stereoscopic coordinate system is an ac stereoscopic coordinate system, wherein the second coordinate axis is a second c-axis, and the fourth coordinate axis is a second a-axis. The first c-axis and the second c-axis have the same or opposite orientation.

In some embodiments, the first stereoscopic coordinate system further includes a fifth coordinate axis along a fifth direction and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction ranges from 0 degree to 5 degrees, and the third direction being opposite to the fourth direction means that the included angle between the vector along the third direction and the vector along the fourth direction ranges from 175 degrees to 180 degrees.

In some embodiments, the first stereoscopic coordinate system is an xyz stereoscopic coordinate system, wherein the first coordinate axis is a first z-axis, the third coordinate axis is a first y-axis, and the fifth coordinate axis is a first x-axis. The second stereoscopic coordinate system is an xyz stereoscopic coordinate system, wherein the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientation, and the first y-axis and the second y-axis have opposite orientation. In some embodiments, the first z-axis and the second z-axis have the same orientation, and the first y-axis and the second y-axis have opposite orientation. In some embodiments, the first z-axis and the second z-axis have opposite orientation, and the first y-axis and the second y-axis have the same orientation.

In some embodiments, the piezoelectric layer 9001 includes a plurality of crystal grains and a crystal composed of the plurality of crystal grains has a full width at half maximum of rocking curve less than 2.5 degrees.

In some embodiments, the material of the first electrode layer 9004 includes, but is not limited to, at least one of the following: molybdenum, ruthenium, tungsten, platinum, iridium, aluminum and beryllium, and the material of the first electrode extension layer 9005 includes, but is not limited to, at least one of the following: molybdenum, ruthenium, tungsten, platinum, iridium, aluminum, beryllium, copper and gold. In some embodiments, the material of the first electrode layer 9004 is the same as that of the first electrode extension layer 9005. In some embodiments, the material of the first sub-layer a is the same as that of the second sub-layer b. In some embodiments, a thickness of the first sub-layer a is greater than 1 nm.

In some embodiments, the material of the second electrode layer 9006 includes, but is not limited to, at least one of the following: molybdenum, ruthenium, tungsten, platinum, iridium, aluminum and beryllium, and the material of the second electrode extension layer 9007 includes, but is not limited to, at least one of the following: molybdenum, ruthenium, tungsten, platinum, iridium, aluminum, beryllium, copper and gold. In some embodiments, the material of the first electrode layer 9006 may be the same as that of the first electrode extension layer 9007. In some embodiments, the material of the third sub-layer c is the same as that of the fourth sub-layer. In some embodiments, a thickness of the third sub-layer c is greater than 1 nm.

In some embodiments, the material of the electrode layer may be different from that of the electrode extension layer.

In some embodiments, the material of the first passivation layer 9008 includes, but is not limited to, one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the second passivation layer 9009 includes, but is not limited to one of the following: silicon dioxide, silicon oxynitride, silicon oxycarbide, silicon nitride, titanium oxide, aluminium oxide, hafnium silicate, zirconium silicate, hafnium dioxide, and zirconium dioxide. In some embodiments, the material of the first passivation layer 9008 may be the same as that of the second passivation layer 9009. In other embodiments, the material of the first passivation layer (e.g., the first passivation layer 9008) may be different from that of the second passivation layer (e.g., the second passivation layer 9009).

In some embodiments, the material of the first overlap layer 9010 includes, but is not limited to, at least one of the following: molybdenum, ruthenium, tungsten, platinum, iridium, aluminum and beryllium. In some embodiments, the material of the first overlap layer 9010 may be the same as that of the first electrode layer 9004.

In some embodiments, the material of the second overlap layer 9011 includes, but is not limited to, at least one of the following: molybdenum, ruthenium, tungsten, platinum, iridium, aluminum and beryllium. In some embodiments, the material of the second overlap layer 9011 may be the same as that of the second electrode layer 9006.

In other embodiments, the material of the overlap layer may be different from that of the electrode layer, for example, the material of the overlap layer is tungsten or platinum, and the material of the electrode layer is molybdenum.

In some embodiments, the overlap layer includes a first overlap sub-layer and a second overlap sub-layer. The first overlap sub-layer contacts the passivation layer, the second overlap sub-layer contacts the first overlap sub-layer, and the second overlap sub-layer and the passivation layer are disposed at two opposite sides of the first overlap sub-layer. The material of the first overlap sub-layer may be different from that of the second overlap sub-layer, for example, the material of the first overlap sub-layer on the passivation layer is molybdenum, and the material of the second overlap sub-layer on the first overlap sub-layer is platinum or tungsten.

In some embodiments, the bulk acoustic wave resonance device 9000 further includes a first passive structure 9012 and a second passive structure 9013. The first passive structure 9012 is disposed at the first side 9002 and contacts the first edge of the first sub-layer, the third edge of the second sub-layer b and the piezoelectric layer 9001 outside the first edge. The first passive structure 9012 includes the first overlap layer 9010 and a first passivation portion (not marked) that is a part of the first passivation layer 9008 overlapping with the first overlap layer 9010. The second passive structure 9013 is disposed at the second side 9003 and contacts the sixth edge of the third sub-layer, the eighth edge of the fourth sub-layer and the piezoelectric layer 9001 outside the sixth edge. The second passive structure 9013 includes the second overlap layer 9011 and a second passivation portion (not marked) that is a part of the second passivation layer 9009 overlapping with the second overlap layer 9011. It should be noted that the passivation portions may include a dielectric material, which can electrically isolate the overlap layers from the electrode layers, so that the electrode layers and the overlap layers are not electrically coupled, thus the overlap layers are passive, and thus a combination structure of the passivation portion and the overlap layer is also passive.

In some embodiments, a first thickness of the first passive structure 9012 is less than a thickness of the first electrode layer 9004, a second thickness of the second passive structure 9013 is less than a thickness of the second electrode layer 9006, and the first thickness is equal to or approximately equal to the second thickness.

In some embodiments, a first width of the first raised portion matches with a wavelength of major-mode transverse acoustic waves generated in the resonance region 9100, such as Rayleigh-Lamb 1st order mode or 1st order Thickness Extension mode (for example, the first width is an integer multiple of the half wavelength). A second width of the second raised portion matches with the wavelength of the major-mode transverse acoustic waves generated in the resonance region 9100 (for example, the second width is equal to an integer multiple of the half wavelength), and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, the first sub-layer a is disposed at one side of the first raised portion in the vertical direction, the second sub-layer b is disposed at one side of the first raised portion in the horizontal direction, the third sub-layer is disposed at one side of the second raised portion in the vertical direction, and the fourth sub-layer is disposed at one side of the second raised portion in the horizontal direction. It should be noted that the thickness of the raised portion matches with the thickness of the sub-layer (i.e., the second sub-layer b and the fourth sub-layer d) of the electrode layer in the horizontal direction, that is, the thickness of the raised portion is approximate to the thickness of the sub-layer, which can improve the continuity of the acoustic waves propagating from the resonance region into the evanescent region so as to reduce spurious resonance generated during the propagation process.

In some embodiments, a third thickness of the first extension portion is less than the thickness of the first electrode layer 9004, a fourth thickness of the second extension portion is less than the thickness of the second electrode layer 9006, and the third thickness is equal to or approximately equal to the fourth thickness.

In some embodiments, an overlap region of the first extension portion, the second electrode extension layer 9007 and the piezoelectric layer 9001 forms an evanescent region 9200, and an overlap region of the second extension portion, the first electrode extension layer 9005 and the piezoelectric layer 9001 forms an evanescent region 9300. A second cutoff frequency of the evanescent region 9200 matches with (for example, equal to or less than) a first cutoff frequency of the resonance region 9100, a third cutoff frequency of the evanescent region 9300 matches (for example, equal to or less than) the first cutoff frequency of the first resonance region 9100, and the second cutoff frequency is equal to or approximately equal to the third cutoff frequency.

It should be noted that the cutoff frequency of the evanescent region matches with the cutoff frequency of the resonance region, which can result in the acoustic waves entering the evanescent region are in the evanescent mode, that is, the wave number in the evanescent region only includes an imaginary part, resulting in exponential decay of the acoustic waves. It should be noted that the passive structures can decay the transverse acoustic waves generated in the resonance region so as to suppress lateral spurious mode to improve the parallel impedance Zₚ and corresponding Q value, and thus the impact of the passive structures on Kt² is relatively small.

In some embodiments, the bulk acoustic wave resonance device 9000 further includes a cavity 9014. The first electrode layer 9004 is disposed in the cavity 9014, one end of the first electrode extension layer 9005 is disposed in the cavity 9014, and the first passive structure 9012 is disposed in the cavity 9014. In other embodiments, a lower electrode layer (i.e., the first electrode layer 9004) may be disposed above the cavity and cover the cavity. The passive structure corresponding to the lower electrode layer is disposed outside the cavity.

FIG. 13 illustrates a schematic structure view of a cross-section B of the bulk acoustic wave resonance device 9000 according to an embodiment of the present disclosure.

As shown in FIG. 13, the bulk acoustic wave resonance device 9000 includes the piezoelectric layer 9001, the first electrode layer 9004, the second electrode layer 9006, the first passivation layer 9008, the second passivation layer 9009, the first overlap layer 9010 and the second overlap layer 9011. The piezoelectric layer 9001 includes the first side 9002 and the second side 9003. The first electrode layer 9004 is disposed at the first side 9002 and contacts the piezoelectric layer 9001. The first electrode layer 9004 includes the first sub-layer a and the second sub-layer b. The first sub-layer a contacts the piezoelectric layer 9001, and the second sub-layer b contacts the first sub-layer a. The first sub-layer a is disposed between the piezoelectric layer 9001 and the second sub-layer b. The first sub-layer a also includes a ninth edge and a tenth edge opposite to the ninth edge in the horizontal direction. The ninth edge has a ramp-down shape, and the tenth edge has a ramp-down shape. The second sub-layer b also includes an eleventh edge and a twelfth edge opposite to the eleventh edge in the horizontal direction. The eleventh edge has a ramp-down shape, and the twelfth edge has a ramp-down shape. The eleventh edge is disposed at an inner side to the ninth edge, the twelfth edge is disposed at an inner side to the tenth edge, and the dimension of the second sub-layer b is smaller than the dimension of the first sub-layer a. The second electrode layer 9006 is disposed at the second side 9003 and contacts the piezoelectric layer 9001. The second electrode layer 9006 includes the third sub-layer c and the fourth sub-layer d. The third sub-layer c contacts the piezoelectric layer 9001, and the fourth sub-layer d contacts the third sub-layer c. The third sub-layer c is disposed between the piezoelectric layer 9001 and the fourth sub-layer d. The third sub-layer c includes a thirteenth edge and a fourteenth edge opposite to the thirteenth edge in the horizontal direction. The thirteenth edge has a ramp-down shape, and the fourteenth edge has a ramp-down shape. The fourth sub-layer d includes a fifteenth edge and a sixteenth edge opposite to the fifteenth edge in the horizontal direction. The fifteenth edge has a ramp-down shape, and the sixteenth edge has a ramp-down shape. The fifteenth edge is disposed at an inner side to the thirteenth edge, the sixteenth edge is disposed at an inner side to the fourteenth edge, that is, the dimension of the fourth sub-layer d is smaller than the dimension of the third sub-layer c. In the resonance region 9100, the ninth edge corresponds to the thirteenth edge in the vertical direction, the tenth edge corresponds to the fourteenth edge in the vertical direction, the eleventh edge corresponds to the fifteenth edge in the vertical direction, and the twelfth edge corresponds to the sixteenth edge in the vertical direction. The first passivation layer 9008 is disposed at the first side 9002. One part of the first passivation layer 9008 in the resonance region 9100 covers the first electrode layer 9004. The second passivation layer 9009 is disposed at the second side 9003. One part of the second passivation layer 9009 in the resonance region 9100 covers the second electrode layer 9006. The first overlap layer 9010 is disposed at the first side 9002 and contacts the first passivation layer 9008. The first overlap layer 9010 includes the first raised portion (not marked) and the first extension portion (not marked), and the first raised portion protrudes relative to the first extension portion. The first raised portion is disposed in the resonance region 9100, and has a third overlap portion overlapping with the ninth edge and a fourth overlap portion overlapping with the tenth edge. The third overlap portion extends to the eleventh edge in the horizontal direction, and the fourth overlap portion extends to the twelfth edge in the horizontal direction. The first raised portion and the first electrode layer 9004 are disposed at two opposite sides of the first passivation layer 9008, and the first extension portion is disposed outside the resonance region 9100 and outside the ninth edge and the tenth edge. The first extension portion does not overlap with the first electrode layer 9004, and the first gap 9015 is disposed between the first extension portion and the piezoelectric layer 9001. The second overlap layer 9011 is disposed at the second side 9003 and contacts the second passivation layer 9009. The second overlap layer 9011 includes the second raised portion (not marked) and the second extension portion (not marked), and the second raised portion protrudes relative to the second extension portion. The second raised portion is disposed in the resonance region 9100, and has a fifth overlap portion overlapping with the thirteenth edge and a sixth overlap portion overlapping with the fourteenth edge. The fifth overlap portion extends to the fifteenth edge in the horizontal direction, and the sixth overlap portion extends to the sixteenth edge in the horizontal direction. The second raised portion and the second electrode layer 9006 are disposed at two opposite sides of the second passivation layer 9009, and the second extension portion is disposed outside the resonance region 9100 and outside the thirteenth edge and the fourteenth edge. The second extension portion does not overlap with the second electrode layer 9006, and the second gap 9016 is disposed between the second extension portion and the piezoelectric layer 9001.

In some embodiments, an overlap region of the first extension portion, the second extension portion and the piezoelectric layer 9001 forms an evanescent region 9400. A fourth cutoff frequency of the evanescent region 9400 matches with (for example, equal to or less than) the first cutoff frequency of the resonance region 9100.

FIG. 14 illustrates a schematic structural view of a wireless communication device 1000. As shown in FIG. 14, the wireless communication device 1000 includes an RF front-end device 1010, a baseband processing device 1030 and an antenna 1050. A first end of the RF front-end device 1010 is coupled with the baseband processing device 1030, and a second end of the RF front-end device 1010 is coupled with the antenna 1050. The RF front-end device 1010 includes a first filtering device 1011, a second filtering device 1013, a multiplexing device 1015, a power amplification device 1017 and a low noise amplification device 1019. The first filtering device 1011 is coupled with the power amplification device 1017, and the second filtering device 1013 is electrically coupled with the low noise amplification device 1019. The multiplexing device 1015 includes at least one transmitting filtering device (not shown) and at least one receiving filtering device (not shown). The first filtering device 1011 includes at least one bulk acoustic wave resonance device according to any one of preceding embodiments, and the second filtering device 1013 includes at least one bulk acoustic wave resonance device according to any one of preceding embodiments. The at least one transmitting filtering device includes at least one bulk acoustic wave resonance device according to any one of preceding embodiments, or the at least one receiving filtering device includes at least one bulk acoustic wave resonance device according to any one of preceding embodiments.

FIG. 15 illustrates a method for forming a bulk acoustic wave resonance device according to a specific embodiment of the present disclosure. However, the present disclosure can also be implemented in other ways different from the specific embodiment described herein, so the present disclosure is not limited by the specific embodiment disclosed below.

FIG. 15 illustrates a flowchart of a method 1100 for forming a bulk acoustic wave resonance device according to an embodiment of the present disclosure.

Another embodiment of the present disclosure provides a method for forming a bulk acoustic wave resonance device. The method includes steps of:
S1101: forming a piezoelectric layer, wherein the piezoelectric layer includes a first side and a second side opposite to the first side in a vertical direction; forming a first electrode layer at the first side, wherein forming the first electrode layer includes forming a first sub-layer and a second sub-layer contacting the first sub-layer, and the first sub-layer, disposed between the second sub-layer and the piezoelectric layer, contacts the piezoelectric layer; and forming a second electrode layer at the second side, wherein forming the second electrode layer includes forming a third sub-layer and a fourth sub-layer contacting the third sub-layer, the third sub-layer, disposed between the fourth sub-layer and the piezoelectric layer, contacts the piezoelectric layer, and an overlap region of the first sub-layer, the third sub-layer and the piezoelectric layer forms a resonance region.
S1103: forming a first passive structure at the first side, wherein the first passive structure contacts at least one edge of the first sub-layer; wherein the first passive structure includes a first raised portion, a first passivation portion and a first extension portion, and the first raised portion protrudes relative to the first extension portion; wherein the first raised portion, disposed in the resonance region, has a first overlap portion overlapping with the at least one edge of the first sub-layer, and the first raised portion is configured to make acoustic impedance matching of the resonance region and at least one evanescent region outside the resonance region, so that more acoustic waves generated in the resonance region enter the at least one evanescent region; wherein the first passivation portion is disposed between the first raised portion and the first electrode layer for electrically isolating the first passive structure from the first electrode layer, and the first passivation portion contacts the at least one edge of the first sub-layer; wherein the first extension portion is disposed outside the resonance region and in the at least one evanescent region for decaying the acoustic waves entering the at least one evanescent region.
S1105: forming a second passive structure at the second side, wherein the second passive structure contacts at least one edge of the third sub-layer; wherein the second passive structure includes a second raised portion, a second passivation portion and a second extension portion, and the second raised portion protrudes relative to the second extension portion; wherein the second raised portion, disposed in the resonance region, has a second overlap portion overlapping with the at least one edge of the third sub-layer, and the second raised portion is configured to make acoustic impedance matching of the resonance region and the at least one evanescent region, so that more acoustic waves generated in the resonance region enter the at least one evanescent region; wherein the second passivation portion is disposed between the second raised portion and the second electrode layer for electrically isolating the second passive structure from the second electrode layer, and the second passivation portion contacts the at least one edge of the third sub-layer; wherein the second extension portion is disposed outside the resonance region and in the at least one evanescent region for decaying the acoustic waves entering the at least one evanescent region.

In some embodiments, forming the first sub-layer includes forming a first ramp-down edge corresponding to the first passive structure, and forming the third sub-layer includes forming a second ramp-down edge corresponding to the second passive structure.

In some embodiments, a dimension of the second sub-layer is smaller than a dimension of the first sub-layer, and a dimension of the fourth sub-layer is smaller than a dimension of the third sub-layer.

In some embodiments, at least one edge of the second sub-layer is disposed at an inner side to at least one corresponding edge of the first sub-layer, and at least one edge of the fourth sub-layer is disposed at an inner side to at least one corresponding edge of the third sub-layer.

In some embodiments, the first passive structure and the second passive structure surround the resonance region.

In some embodiments, a thickness of the first passive structure is equal to or less than a thickness of the first electrode layer, and a thickness of the second passive structure is equal to or less than a thickness of the second electrode layer.

In some embodiments, forming the first passive structure includes: forming a first passivation layer covering the first electrode layer at the first side; and forming a first overlap layer contacting the first passivation layer and having an overlap portion overlapping with the at least one edge of the first sub-layer; wherein the first passivation layer includes the first passivation portion, and the first overlap layer includes the first raised portion and the first extension portion.

In some embodiments, forming the second passive structure includes: forming a second passivation layer covering the second electrode layer at the second side; and forming a second overlap layer contacting the second passivation layer and having an overlap portion overlapping with the at least one edge of the third sub-layer; wherein the second passivation layer includes the second passivation portion, and the second overlap layer includes the second raised portion and the second extension portion.

In some embodiments, the at least one evanescent region includes a first evanescent region having a first cutoff frequency equal to or less than a cutoff frequency of the resonance region, and the first evanescent region corresponds to an overlap region of the first extension portion, the piezoelectric layer and the second extension portion.

In some embodiments, the method further includes: forming a first electrode extension layer at the first side and forming a second electrode extension layer at the second side. The first electrode extension layer is coupled with the first electrode layer, and the second electrode extension layer is coupled with the second electrode layer.

In some embodiments, the at least one evanescent region includes a second evanescent region having a second cutoff frequency equal to or less than a cutoff frequency of the resonance region, and the second evanescent region corresponds to an overlap region of the second electrode extension layer, the piezoelectric layer and the first extension portion.

In some embodiments, the at least one evanescent region includes a third evanescent region having a third cutoff frequency equal to or less than a cutoff frequency of the resonance region, and the third evanescent region corresponds to an overlap region of the second extension portion, the piezoelectric layer and the first electrode extension layer.

In some embodiments, the first overlap portion extends to at least one corresponding edge of the second sub-layer in a horizontal direction, and the second overlap portion extends to at least one corresponding edge of the fourth sub-layer in the horizontal direction.

In some embodiments, the first sub-layer is disposed at one side of the first raised portion in the vertical direction, the second sub-layer is disposed at one side of the first raised portion in a horizontal direction, the third sub-layer is disposed at one side of the second raised portion in the vertical direction, and the fourth sub-layer is disposed at one side of the second raised portion in the horizontal direction.

In some embodiments, a thickness of the first extension portion is smaller than a thickness of the first electrode layer, and a thickness of the second extension portion is smaller than a thickness of the second electrode layer.

In some embodiments, a width of the first raised portion is an integer multiple of a half wavelength of the acoustic waves generated in the resonance region, and a width of the second raised portion is an integer multiple of the half wavelength of the acoustic waves generated in the resonance region.

In some embodiments, forming the first overlap layer includes forming a first overlap sub-layer and a second overlap sub-layer. The second overlap sub-layer and the piezoelectric layer are disposed at two opposite sides of the first overlap sub-layer, and a material of the first overlap sub-layer is different from a material of the second overlap sub-layer.

In some embodiments, forming the second overlap layer includes forming a third overlap sub-layer and a fourth overlap sub-layer. The fourth overlap sub-layer and the piezoelectric layer are disposed at two opposite sides of the third overlap sub-layer, and a material of the third overlap sub-layer is different from a material of the fourth overlap sub-layer.

In some embodiments, the method further includes: forming a first sacrificial layer between the first extension portion and the piezoelectric layer; and forming a second sacrificial layer between the second extension portion and the piezoelectric layer.

In some embodiments, the method further includes: removing the first sacrificial layer to form a first gap between the first extension portion and the piezoelectric layer; and removing the second sacrificial layer to form a second gap between the second extension portion and the piezoelectric layer.

In some embodiments, the first passivation portion is further disposed between the piezoelectric layer and the first extension portion, and the second passivation portion is further disposed between the piezoelectric layer and the second extension portion.

It should be noted that the raised portions of the passive structures are disposed in the resonance region and have overlap portions overlapping with the electrode layers respectively, which can make acoustic impedance matching of the resonance region and the evanescent region outside the resonance region, so that more acoustic waves generated in the resonance region can propagate into the evanescent region. In addition, the thickness of the raised portion matches with the thickness of the sub-layer of the electrode layer disposed in the horizontal direction, that is, the thickness of the raised portion is approximate to the thickness of the sub-layer, which can improve a continuity of the acoustic waves propagating from the resonance region into the evanescent region so as to reduce a spurious resonance generated during the propagation process. In addition, the cutoff frequency of the evanescent region matches with (for example, equal to or less than) the cutoff frequency of the resonance region, which can decay the acoustic waves entering the evanescent region, so as to suppress lateral spurious mode to improve Zₚ and corresponding Q value, and moreover the impact of the passive structures on Kt² is relatively small. The cutoff frequency is a frequency corresponding to a wave number of 0 on a dispersion curve.

FIGS. 16 to 19 illustrate specific embodiments of a method for forming a bulk acoustic wave resonance device of the present disclosure, but the present disclosure can also be implemented in other ways different from the specific embodiments described herein, so the present disclosure is not limited by the specific embodiments disclosed below.

FIGS. 16 to 19 illustrate schematic structural views of a section A during a method for forming a bulk acoustic wave resonance device 1200 according to an embodiment of the present disclosure.

As shown in FIG. 16, the method for forming the bulk acoustic wave resonance device 1200 includes: forming a piezoelectric layer 1201, wherein the piezoelectric layer 1201 includes a first side 1202 and a second side 1203 opposite to the first side 1202 in a vertical direction. The method further includes: forming a first electrode layer 1204 at the first side 1201, wherein the first electrode layer 1204 contacts the piezoelectric layer 1201. Forming the first electrode layer 1204 includes forming a first sub-layer a and a second sub-layer b. The first sub-layer a contacts the piezoelectric layer 1201, the second sub-layer b contacts the first sub-layer a, and the first sub-layer a is disposed between the second sub-layer b and the piezoelectric layer 1201. The first sub-layer a includes a first edge and a second edge opposite to the first edge in a horizontal direction. The second sub-layer b includes a third edge and a fourth edge opposite to the third edge in the horizontal direction. The third edge is disposed at an inner side to the first edge, and the fourth edge is aligned with the second edge. A dimension of the second sub-layer b is smaller than a dimension of the first sub-layer a. The method further includes: forming a first electrode extension layer 1205 at the first side 1202. The first electrode extension layer 1205 is coupled with the second edge and the fourth edge of the first electrode layer 1204.

In some embodiments, the method for forming the bulk acoustic wave resonance device 1200 further includes: providing a first substrate (not shown) before forming the piezoelectric layer 1201. In some embodiments, the piezoelectric layer 1201 is formed at one side of the first substrate, and the first substrate is disposed at the second side 1203.

In some embodiments, forming the first electrode layer 1204 includes: forming a first ramp-down edge at the first edge, and forming a second ramp-down edge at the third edge.

As shown in FIG. 17, the method for forming the bulk acoustic wave resonance device 1200 further includes: forming a first passivation layer 1206 at the first side 1202. The first passivation layer 1206 covers the first electrode layer 1204, and the first passivation layer 1206 also covers the piezoelectric layer 1201 outside the first edge and covers the first electrode extension layer 1205 outside the second edge and the fourth edge. The method further includes: forming a first overlap layer 1207 at the first side 1202. The first overlap layer 1207 contacts the first passivation layer 1206. The first overlap layer 1207 includes a first raised portion (not marked) and a first extension portion (not marked), and the first raised portion protrudes relative to the first extension portion. The first raised portion is disposed at an inner side to the first edge and has a first overlap portion overlapping with the first edge. The first overlap portion extends to the third edge in the horizontal direction. The first raised portion and the first electrode layer 1204 are disposed at two opposite sides of the first passivation layer 1206. The first extension portion is disposed outside the first edge, and does not overlap with the first electrode layer 1204. The first extension portion and the piezoelectric layer 1201 are disposed at two opposite sides of the first passivation layer 1206.

In some embodiments, the method for forming the bulk acoustic wave resonance device 1200 further includes: forming a sacrificial layer 1208 at the first side 1202. The sacrificial layer 1208 covers the first electrode layer 1204, one end of the first electrode extension layer 1205 coupled with the second edge and the fourth edge, and the first overlap layer 1207. The first passivation layer 1206 is disposed between the first electrode layer 1204 and the sacrificial layer 1208 and between the first electrode extension layer 1205 and the sacrificial layer 1208 as well.

In some embodiments, the method for forming the bulk acoustic wave resonance device 1200 further includes: forming a first connecting layer (not shown) at the first side 1202. The first connecting layer covers the sacrificial layer 1208 and the first passivation layer 1206.

In some embodiments, the method for forming the bulk acoustic wave resonance device further includes: forming a sacrificial layer having an overlap portion overlapping with a lower electrode layer (i.e., the first electrode layer 1204). A passivation layer is disposed between the sacrificial layer and the lower electrode layer, a lower overlap layer corresponding to the lower electrode layer is disposed at a first side of the sacrificial layer in the horizontal direction, and a lower electrode extension layer is disposed at a second side of the sacrificial layer in the horizontal direction. The method further includes: forming a connecting layer covering the sacrificial layer, the lower overlap layer and the passivation layer.

In some embodiments, the method for forming the bulk acoustic wave resonance device 1200 further includes: providing a second substrate (not shown); forming a second connecting layer (not shown) at one side of the second substrate and covering the second substrate; connecting the first connecting layer with the second connecting layer to form an intermediate layer (not shown), wherein the second substrate and the intermediate layer are disposed at the first side 1202; and removing the first substrate. In some embodiments, connecting the first connecting layer with the second connecting layer includes bonding the first connecting layer with the second connecting layer or adhering the first connecting layer to the second connecting layer.

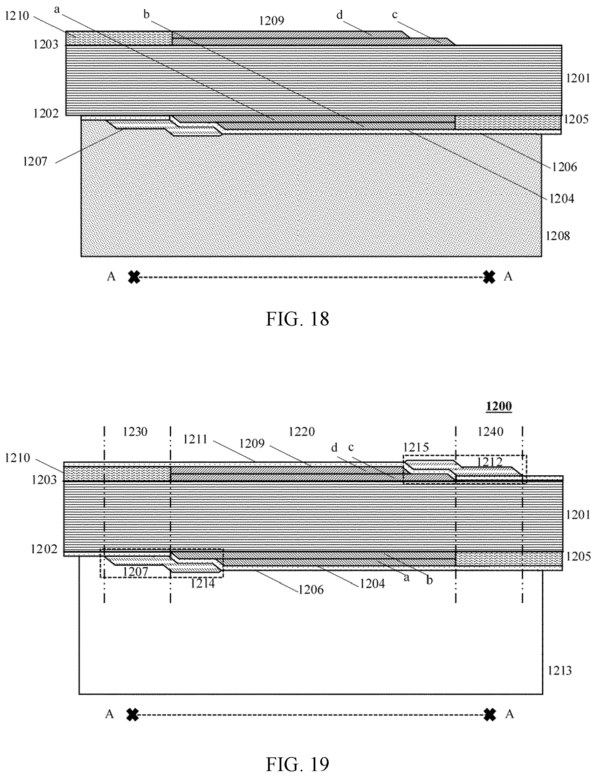

As shown in FIG. 18, the method for forming the bulk acoustic wave resonance device 1200 further includes: forming a second electrode layer 1209 at the second side 1203. The second electrode layer 1209 contacts the piezoelectric layer 1201. Forming the second electrode layer 1209 includes forming a third sub-layer c and a fourth sub-layer d. The third sub-layer c contacts the piezoelectric layer 1201, and the fourth sub-layer d contacts the third sub-layer c. The third sub-layer c is disposed between the piezoelectric layer 1201 and the fourth sub-layer d. The third sub-layer c includes a fifth edge and a sixth edge opposite to the fifth edge in the horizontal direction, and the fourth sub-layer d includes a seventh edge and an eighth edge opposite to the seventh edge in the horizontal direction. The eighth edge is disposed at an inner side to the sixth edge, the fifth edge is aligned with the seventh edge, and a dimension of the fourth sub-layer d is smaller than a dimension of the third sub-layer c. The method further includes: forming a second electrode extension layer 1210 at the second side 1203. The second electrode extension layer 1210 contacts the piezoelectric layer 1201 and is coupled with the fifth edge and the seventh edge of the second electrode layer 1209. The fifth edge and the seventh edge correspond to the first edge in the vertical direction, and the sixth edge corresponds to the second edge and the fourth edge in the vertical direction.

In some embodiments, forming the second electrode layer 1209 includes forming a third ramp-down edge at the sixth edge and forming a fourth ramp-down edge at the eighth edge.

As shown in FIG. 19, the method for forming the bulk acoustic wave resonance device 1200 further includes: forming a second passivation layer 1211 at the second side 1203. The second passivation layer 1211 covers the second electrode layer 1209, and the second passivation layer 1211 also covers the piezoelectric layer 1201 outside the sixth edge and covers the second electrode extension layer 1210 outside the fifth edge and the seventh edge. The method further includes: forming a second overlap layer 1212 at the second side 1203. The second overlap layer 1212 contacts the second passivation layer 1211. The second overlap layer 1212 includes a second raised portion (not marked) and a second extension portion (not marked), and the second raised portion protrudes relative to the second extension portion. The second raised portion is disposed at an inner side to the sixth edge and has a second overlap portion overlapping with the sixth edge. The second overlap portion extends to the eighth edge in the horizontal direction. The second raised portion and the second electrode layer 1209 are disposed at two opposite sides of the second passivation layer 1211. The second extension portion is disposed outside the sixth edge, and does not overlap with the second electrode layer 1209. The second extension portion and the piezoelectric layer 1201 are disposed at two opposite sides of the second passivation layer 1211.

In some embodiments, the method for forming the bulk acoustic wave resonance device 1200 further includes removing the sacrificial layer 1208 to form a cavity 1213. The first electrode layer 1204, one end of the first electrode extension layer 1205 coupled with the second edge and the fourth edge and the first overlap layer 1207 are disposed in the cavity 1213.

In some embodiments, the first overlap layer 1207 and a first passivation portion (not marked) that is a part of the first passivation layer 1206 overlapping with the first overlap layer 1207 form a first passive structure 1214. The first passive structure 1214 is disposed at the first side 1202 and contacts the first edge of the first sub-layer a, the third edge of the second sub-layer b and the piezoelectric layer 1201 outside the first edge. The second overlap layer 1212 and a second passivation portion (not marked) that is a part of the second passivation layer 1211 overlapping with the second overlap layer 1212 form a second passive structure 1215. The second passive structure 1215 is disposed at the second side 1203 and contacts the sixth edge of the third sub-layer c, the eighth edge of the fourth sub-layer d and the piezoelectric layer 1201 outside the sixth edge. It should be noted that the passivation portions may include a dielectric material, which can electrically isolate the overlap layers from the electrode layers, so that the electrode layers and the overlap layers are not electrically coupled, thus the overlap layers are passive, and thus a combination structure of the passivation portion and the overlap layer is also passive.

In some embodiments, a first thickness of the first passive structure 1214 is less than a thickness of the first electrode layer 1204, a second thickness of the second passive structure 1215 is less than a thickness of the second electrode layer 1209, and the first thickness is equal to or approximately equal to the second thickness.

In some embodiments, an overlap region of the first sub-layer a, the third sub-layer c and the piezoelectric layer 1201 forms a resonance region 1220, an overlap region of the first extension portion, the second electrode extension layer 1210, and the piezoelectric layer 1201 form an evanescent region 1230, and an overlap region of the second extension portion, the first electrode extension layer 1205 and the piezoelectric layer 1201 form an evanescent region 1240. A second cutoff frequency of the evanescent region 1230 matches with (for example, equal to or less than) a first cutoff frequency of the resonance region 1220, a third cutoff frequency of the evanescent region 1240 matches with (for example, equal to or less than) the first cutoff frequency of the resonance region 1220, and the second cutoff frequency is equal to or approximately equal to the third cutoff frequency.

In some embodiments, a first width of the first raised portion matches with a wavelength of major-mode transverse acoustic waves generated in the resonance region, such as Rayleigh-Lamb 1st order mode or 1st order Thickness Extension mode (for example, the first width is an integer multiple of the half wavelength). A second width of the second raised portion matches with the wavelength of the major-mode transverse acoustic waves generated in the resonance region (for example, the second width is equal to an integer multiple of the half wavelength), and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, the first sub-layer a is disposed at one side of the first raised portion in the vertical direction, the second sub-layer b is disposed at one side of the first raised portion in the horizontal direction, the third sub-layer is disposed at one side of the second raised portion in the vertical direction, and the fourth sub-layer is disposed at one side of the second raised portion in the horizontal direction. It should be noted that the thickness of the raised portion matches with the thickness of the sub-layer (i.e., the second sub-layer b and the fourth sub-layer d) of the electrode layer disposed in the horizontal direction, that is, the thickness of the raised portion is approximate to the thickness of the sub-layer, which can improve the continuity of the acoustic waves propagating from the resonance region into the evanescent region so as to reduce a spurious resonance generated during the propagation process.

In some embodiments, a third thickness of the first extension portion is less than the thickness of the first electrode layer 1204, a fourth thickness of the second extension portion is less than the thickness of the second electrode layer 1209, and the third thickness is equal to or approximately equal to the fourth thickness.

It should be noted that the cutoff frequency of the evanescent region matches with the cutoff frequency of the resonance region, which result in the acoustic waves entering the evanescent region are in the evanescent mode, that is, the wave number in the evanescent region only includes an imaginary part, resulting in exponential decay of the acoustic waves. It should be noted that the passive structures can decay the transverse acoustic waves generated in the resonance region, so as to suppress lateral spurious mode to improve the parallel impedance Zₚ and corresponding Q value, and moreover the impact of the passive structures on Kt² is relatively small.

In some embodiments, forming the overlap layer includes forming a first overlap sub-layer and a second overlap sub-layer. The first overlap sub-layer contacts the passivation layer, the second overlap sub-layer contacts the first overlap sub-layer, and the second overlap sub-layer and the passivation layer are disposed at two opposite sides of the first overlap sub-layer. A material of the first overlap sub-layer may be different from that of the second overlap sub-layer, for example, the material of the first overlap sub-layer is molybdenum, and the material of the second overlap sub-layer is platinum or tungsten.

FIGS. 20 to 23 illustrate specific embodiments of a method for forming a bulk acoustic wave resonance device of the present disclosure, but the present disclosure can also be implemented in other ways different from the specific embodiments described herein, so the present disclosure is not limited by the specific embodiments disclosed below.

FIGS. 20 to 23 illustrate schematic structural views of a section A during a method for forming a bulk acoustic wave resonance device 1300 according to an embodiment of the present disclosure.

As shown in FIG. 20, the method for forming the bulk acoustic wave resonance device 1300 includes: forming a piezoelectric layer 1301, wherein the piezoelectric layer 1301 includes a first side 1302 and a second side 1303 opposite to the first side 1302 in a vertical direction. The method further includes: forming a first electrode layer 1304 at the first side 1302, wherein the first electrode layer 1304 contacts the piezoelectric layer 1301. Forming the first electrode layer 1304 includes forming a first sub-layer a and a second sub-layer b. The first sub-layer a contacts the piezoelectric layer 1301, the second sub-layer b contacts the first sub-layer a, and the first sub-layer a is disposed between the second sub-layer b and the piezoelectric layer 1301. The first sub-layer a includes a first edge and a second edge opposite to the first edge in a horizontal direction. The second sub-layer b includes a third edge and a fourth edge opposite to the third edge in the horizontal direction. The third edge is disposed at an inner side to the first edge, and the fourth edge is aligned with the second edge. A dimension of the second sub-layer b is smaller than a dimension of the first sub-layer a. The method further includes: forming a first electrode extension layer 1305 at the first side 1302, wherein the first electrode extension layer 1305 is coupled with the second edge and the fourth edge of the first electrode layer 1304.

In some embodiments, the method for forming the bulk acoustic wave resonance device 1300 further includes: providing a first substrate (not shown) before forming the piezoelectric layer 1301. In some embodiments, the piezoelectric layer 1301 is formed at one side of the first substrate, and the first substrate is disposed at the second side 1303.

In some embodiments, forming the first electrode layer 1304 includes: forming a first ramp-down edge at the first edge, and forming a second ramp-down edge at the third edge.

As shown in FIG. 21, the method for forming the bulk acoustic wave resonance device 1300 further includes: forming a first passivation layer 1306 at the first side 1302. The first passivation layer 1306 covers the first electrode layer 1304, and also covers the first electrode extension layer 1305 outside the second edge and the fourth edge. The method further includes: forming a sacrificial layer 1307 at the first side 1202. The sacrificial layer 1307 is disposed outside the first edge and contacts the piezoelectric layer 1301 and the first passivation layer 1306. The method further includes: forming a first overlap layer 1308 at the first side 1302. The first overlap layer 1308 contacts the first passivation layer 1306 and the sacrificial layer 1307. The first overlap layer 1308 includes a first raised portion (not marked) and a first extension portion (not marked), and the first raised portion protrudes relative to the first extension portion. The first raised portion is disposed at an inner side to the first edge and has a first overlap portion overlapping with the first edge. The first overlap portion extends to the third edge in the horizontal direction. The first raised portion and the first electrode layer 1304 are disposed at two opposite sides of the first passivation layer 1306. The first extension portion is disposed outside the first edge, and does not overlap with the first electrode layer 1304. The first extension portion and the piezoelectric layer 1301 are disposed at two opposite sides of the sacrificial layer 1307.

In some embodiments, the method for forming the bulk acoustic wave resonance device 1300 further includes: forming a sacrificial layer 1309 at the first side 1302. The sacrificial layer 1309 covers the first electrode layer 1304, one end of the first electrode extension layer 1305 coupled with the second edge and the fourth edge, the first overlap layer 1308 and the sacrificial layer 1307. The first passivation layer 1306 is disposed between the first electrode layer 1304 and the sacrificial layer 1309, and between the first electrode extension layer 1305 and the sacrificial layer 1309 as well.

In some embodiments, the method for forming the bulk acoustic wave resonance device 1300 further includes: forming a first connecting layer (not shown) at the first side 1302. The first connecting layer covers the sacrificial layer 1309 and the first passivation layer 1306.

In some embodiments, the method for forming the bulk acoustic wave resonance device 1300 further includes: providing a second substrate (not shown); forming a second connecting layer (not shown) at one side of the second substrate and covering the second substrate; connecting the first connecting layer with the second connecting layer to form an intermediate layer (not shown), wherein the second substrate and the intermediate layer are disposed at the first side 1302; and removing the first substrate. In some embodiments, connecting the first connecting layer with the second connecting layer includes bonding the first connecting layer with the second connecting layer or adhering the first connecting layer to the second connecting layer.

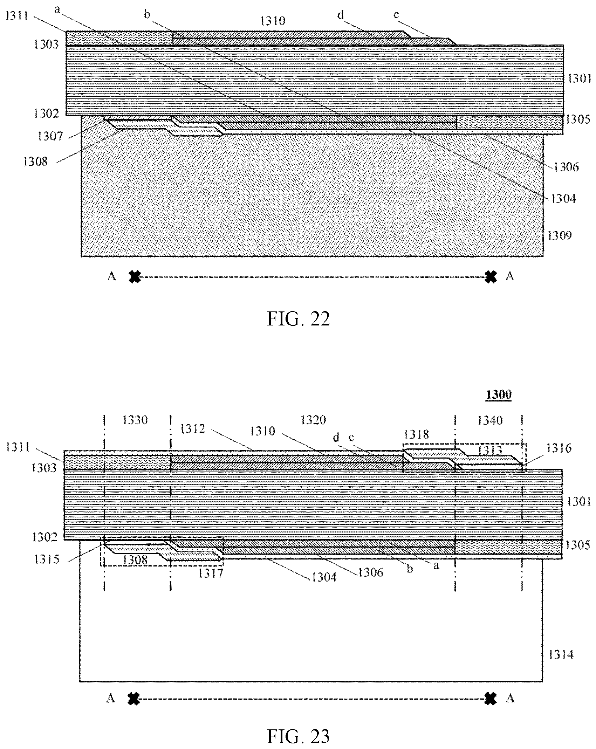

As shown in FIG. 22, the method for forming the bulk acoustic wave resonance device 1300 further includes: forming a second electrode layer 1310 at the second side 1303 and contacting the piezoelectric layer 1301. Forming the second electrode layer 1310 includes forming a third sub-layer c and a fourth sub-layer d. The third sub-layer c contacts the piezoelectric layer 1301, and the fourth sub-layer d contacts the third sub-layer c. The third sub-layer c is disposed between the piezoelectric layer 1301 and the fourth sub-layer d. The third sub-layer c includes a fifth edge and a sixth edge opposite to the fifth edge in the horizontal direction, and the fourth sub-layer d includes a seventh edge and an eighth edge opposite to the seventh edge in the horizontal direction. The eighth edge is disposed at an inner side to the sixth edge, the fifth edge is aligned with the seventh edge, and a dimension of the fourth sub-layer d is smaller than a dimension of the third sub-layer c. The method further includes forming a second electrode extension layer 1311 at the second side 1303. The second electrode extension layer 1311 contacts the piezoelectric layer 1301 and is coupled with the fifth edge and the seventh edge of the second electrode layer 1310. The fifth edge and the seventh edge correspond to the first edge in the vertical direction, and the sixth edge corresponds to the second edge and the fourth edge in the vertical direction.

In some embodiments, forming the second electrode layer 1310 includes forming a third ramp-down edge at the sixth edge and forming a fourth ramp-down edge at the eighth edge.

As shown in FIG. 23, the method for forming the bulk acoustic wave resonance device 1300 further includes: forming a second passivation layer 1312 at the second side 1303. The second passivation layer 1312 covers the second electrode layer 1310, and also covers the second electrode extension layer 1311 outside the fifth edge and the seventh edge. The method further includes: forming a gap sacrificial layer (not shown in the drawings, for example, the sacrificial layer 1307) at the second side 1303, wherein the gap sacrificial layer is disposed outside the six edge and contacts the piezoelectric layer 1301 and the second passivation layer 1312. The method further includes: forming a second overlap layer 1313 at the second side 1303. The second overlap layer 1313 contacts the second passivation layer 1312 and the gap sacrificial layer. The second overlap layer 1313 includes a second raised portion (not marked) and a second extension portion (not marked), and the second raised portion protrudes relative to the second extension portion. The second raised portion is disposed at an inner side to the sixth edge and has a second overlap portion overlapping with the sixth edge. The second overlap portion extends to the eighth edge in the horizontal direction. The second raised portion and the second electrode layer 1310 are disposed at two opposite sides of the second passivation layer 1312. The second extension portion is disposed outside the sixth edge, and does not overlap with the second electrode layer 1310. The second extension portion and the piezoelectric layer 1301 are disposed at two opposite sides of the gap sacrificial layer.

In some embodiments, the method for forming the bulk acoustic wave resonance device 1300 further includes removing the sacrificial layer 1309 to form a cavity 1314. The first electrode layer 1304, one end of the first electrode extension layer 1305 coupled with the second edge and the fourth edge and the first overlap layer 1308 are disposed in the cavity 1314.

In some embodiments, the method for forming the bulk acoustic wave resonance device 1300 further includes removing the sacrificial layer 1307 and the gap sacrificial layer to form a first gap 1315 and a second gap 1316, respectively.

In some embodiments, the first overlap layer 1208, a first passivation portion (not marked) that is a part of the first passivation layer 1306 overlapping with the first overlap layer 1308 and the first gap 1315 form a first passive structure 1317. The first passive structure 1317 is disposed at the first side 1302 and contacts the first edge of the first sub-layer and the third edge of the second sub-layer. The second overlap layer 1313, a second passivation portion (not marked) that is a part of the second passivation layer 1312 overlapping with the second overlap layer 1313 and the second gap 1316 form a second passive structure 1318. The second passive structure 1318 is disposed at the second side 1303 and contacts the six edge of the third sub-layer c and the eighth edge of the fourth sub-layer d. It should be noted that the passivation portions may include a dielectric material, which can electrically isolate the overlap layers from the electrode layers, so that the electrode layers and the overlap layers are not electrically coupled, thus the overlap layers are passive, and thus a combination structure of the passivation portion and the overlap layer is also passive.

In some embodiments, a first thickness of the first passive structure 1317 is less than a thickness of the first electrode layer 1304, a second thickness of the second passive structure 1318 is less than a thickness of the second electrode layer 1310, and the first thickness is equal to or approximately equal to the second thickness.

In some embodiments, an overlap region of the first sub-layer a, the third sub-layer c and the piezoelectric layer 1301 forms a resonance region 1320, an overlap region of the first extension portion, the second electrode extension layer 1311 and the piezoelectric layer 1301 forms an evanescent region 1330, and an overlap region of the second extension portion, the first electrode extension layer 1305 and the piezoelectric layer 1301 form an evanescent region 1340. A second cutoff frequency of the evanescent region 1330 matches with (for example, equal to or less than) a first cutoff frequency of the resonance region 1320, a third cutoff frequency of the evanescent region 1340 matches with (for example, equal to or less than) the first cutoff frequency of the resonance region 1320, and the second cutoff frequency is equal to or approximately equal to the third cutoff frequency.

In some embodiments, a first width of the first raised portion matches with a wavelength of major-mode transverse acoustic waves generated in the resonance region 1320, such as Rayleigh-Lamb 1st order mode or 1st order Thickness Extension mode (for example, the first width is an integer multiple of the half wavelength). A second width of the second raised portion matches with the wavelength of the major-mode transverse acoustic waves generated in the resonance region 1320 (for example, the second width is equal to an integer multiple of the half wavelength), and the first width is equal to or approximately equal to the second width. It should be noted that the first raised portion and the second raised portion are used to make acoustic impedance matching of the resonance region and the evanescent region, so that more acoustic waves generated in the resonance region can propagate into the evanescent region.

In some embodiments, the first sub-layer a is disposed at one side of the first raised portion in the vertical direction, the second sub-layer b is disposed at one side of the first raised portion in the horizontal direction, the third sub-layer is disposed at one side of the second raised portion in the vertical direction, and the fourth sub-layer is disposed at one side of the second raised portion in the horizontal direction. It should be noted that the thickness of the raised portion matches with the thickness of the sub-layer of the electrode layer disposed in the horizontal direction, that is, the thickness of the raised portion is approximate to the thickness of the sub-layer, which can improve the continuity of the acoustic waves propagating from the resonance region into the evanescent region so as to reduce spurious resonance generated during the propagation process.

In some embodiments, a third thickness of the first extension portion is less than the thickness of the first electrode layer 1304, a fourth thickness of the second extension portion is less than the thickness of the second electrode layer 1310, and the third thickness is equal to or approximately equal to the fourth thickness.

It should be noted that the cutoff frequency of the evanescent region matches with the cutoff frequency of the resonance region, which can result in the acoustic waves entering the evanescent region are in the evanescent mode, that is, the wave number in the evanescent region only includes an imaginary part, resulting in exponential decay of the acoustic waves. It should be noted that the passive structures can decay the transverse acoustic waves generated in the resonance region, so as to suppress lateral spurious mode to improve the parallel impedance Zₚ and corresponding Q value, and moreover the impact of the passive structures on Kt² is relatively small.

In some embodiments, forming the overlap layer includes forming a first overlap sub-layer and a second overlap sub-layer. The first overlap sub-layer contacts the passivation layer, the second overlap sub-layer contacts the first overlap sub-layer, and the second overlap sub-layer and the passivation layer are disposed at two opposite sides of the first overlap sub-layer. A material of the first overlap sub-layer may be different from that of the second overlap sub-layer, for example, the material of the first overlap sub-layer is molybdenum, and the material of the second overlap sub-layer is platinum or tungsten.

It should be noted that the raised portions of the passive structures are disposed in the resonance region and have overlap portions overlapping with the electrode layers respectively, which can make acoustic impedance matching of the resonance region and the evanescent region outside the resonance region, so that more acoustic waves generated in the resonance region can propagate into the evanescent region. In addition, the thickness of the raised portion matches with the thickness of the sub-layer of the electrode layer disposed in the horizontal direction, that is, the thickness of the raised portion is approximate to the thickness of the sub-layer, which can improve a continuity of the acoustic waves propagating from the resonance region into the evanescent region so as to reduce a spurious resonance generated during the propagation process. In addition, the cutoff frequency of the evanescent region matches with (for example, equal to or less than) the cutoff frequency of the resonance region, which can decay the acoustic waves entering the evanescent region, so as to suppress lateral spurious mode to improve Zₚ and corresponding Q value, and moreover the impact of the passive structures on Kt² is relatively small.

It should be understood that examples and embodiments herein are only exemplary, and those skilled in the art can make various modifications without departing from the scope of the present invention that is defined by the appended claims.

## Claims

1. A bulk acoustic wave resonance device (300), comprising:
a cavity (3014);
a first electrode layer (3004), wherein at least one end of the first electrode layer is disposed above or in the cavity, and the first electrode layer comprises a first sub-layer(a) and a second sub-layer (b) contacting the first sub-layer;
a piezoelectric layer (3001), wherein the piezoelectric layer comprises a first side and a second side opposite to the first side in a vertical direction, wherein the cavity is disposed at the first side, the first electrode layer is disposed at the first side, and the first sub-layer, disposed between the second sub-layer and the piezoelectric layer, contacts the piezoelectric layer;
a second electrode layer (3006); disposed at the second side, wherein the second electrode layer comprises a third sub-layer (c) and a fourth sub-layer (d) contacting the third sub-layer, the third sub-layer, disposed between the fourth sub-layer and the piezoelectric layer, contacts the piezoelectric layer, and an overlap region of the first sub-layer, the third sub-layer and the piezoelectric layer forms a resonance region;
a first passive structure (3012), disposed at the first side and contacting at least one edge of the first sub-layer; and
a second passive structure (3013), disposed at the second side and contacting at least one edge of the third sub-layer;
wherein the first passive structure comprises:
a first raised portion (3015), disposed in the resonance region and having a first overlap portion overlapping with the at least one edge of the first sub-layer, wherein the first raised portion is configured to make acoustic impedance matching of the resonance region and at least one evanescent region outside the resonance region, so that more acoustic waves generated in the resonance region enter the at least one evanescent region;
a first passivation portion (3008), disposed between the first raised portion and the first electrode layer for electrically isolating the first passive structure from the first electrode layer; and
a first extension portion (3016), disposed outside the resonance region and in the at least one evanescent region for decaying the acoustic waves entering the at least one evanescent region, wherein the first raised portion protrudes relative to the first extension portion;
wherein the second passive structure comprises:
a second raised portion (3017), disposed in the resonance region and having a second overlap portion overlapping with the at least one edge of the third sub-layer, wherein the second raised portion is configured to make acoustic impedance matching of the resonance region and the at least one evanescent region, so that more acoustic waves generated in the resonance region enter the at least one evanescent region;
a second passivation portion (3009), disposed between the second raised portion and the second electrode layer for electrically isolating the second passive structure from the second electrode layer; and
a second extension portion (3018), disposed outside the resonance region and in the at least one evanescent region for decaying the acoustic waves entering the at least one evanescent region, wherein the second raised portion protrudes relative to the second extension portion.

2. The bulk acoustic wave resonance device according to claim 1, wherein the at least one edge of the first sub-layer, corresponding to the first passive structure, has a ramp-down shape, and the at least one edge of the third sub-layer, corresponding to the second passive structure, has a ramp-down shape.

3. The bulk acoustic wave resonance device according to claim 1, wherein a dimension of the second sub-layer is smaller than a dimension of the first sub-layer, and a dimension of the fourth sub-layer is smaller than a dimension of the third sub-layer.

4. The bulk acoustic wave resonance device according to claim 1, wherein at least one edge of the second sub-layer is disposed at an inner side to at least one corresponding edge of the first sub-layer, and at least one edge of the fourth sub-layer is disposed at an inner side to at least one corresponding edge of the third sub-layer.

5. The bulk acoustic wave resonance device according to claim 1, wherein the first passive structure and the second passive structure surround the resonance region.

6. The bulk acoustic wave resonance device according to claim 1, wherein a thickness of the first passive structure is equal to or less than a thickness of the first electrode layer, and a thickness of the second passive structure is equal to or less than a thickness of the second electrode layer.

7. The bulk acoustic wave resonance device according to claim 1, wherein the at least one evanescent region comprises a first evanescent region having a first cutoff frequency equal to or less than a cutoff frequency of the resonance region, and the first evanescent region corresponds to an overlap region of the first extension portion, the piezoelectric layer and the second extension portion.

8. The bulk acoustic wave resonance device according to claim 1, further comprising:
a first electrode extension layer, disposed at the first side and coupled with the first electrode layer; and
a second electrode extension layer, disposed at the second side and coupled with the second electrode layer.

9. The bulk acoustic wave resonance device according to claim 8, wherein the at least one evanescent region comprises a second evanescent region having a second cutoff frequency equal to or less than a cutoff frequency of the resonance region, and the second evanescent region corresponds to an overlap region of the second electrode extension layer, the piezoelectric layer and the first extension portion; and/or
wherein the at least one evanescent region comprises a third evanescent region having a third cutoff frequency equal to or less than the cutoff frequency of the resonance region, and the third evanescent region corresponds to an overlap region of the second extension portion, the piezoelectric layer and the first electrode extension layer.

10. The bulk acoustic wave resonance device according to claim 1, wherein a width of the first raised portion is an integer multiple of a half wavelength of the acoustic waves generated in the resonance region, and a width of the second raised portion is an integer multiple of the half wavelength of the acoustic waves generated in the resonance region.

11. The bulk acoustic wave resonance device according to claim 1, wherein the first raised portion is made of a material including a metal, the first extension portion is made of a material including a metal, the second raised portion is made of a material including a metal, and the second extension portion is made of a material including a metal.

12. The bulk acoustic wave resonance device according to claim 1, wherein the first sub-layer is disposed at one side of the first raised portion in the vertical direction, the second sub-layer is disposed at one side of the first raised portion in a horizontal direction, the third sub-layer is disposed at one side of the second raised portion in the vertical direction, and the fourth sub-layer is disposed at one side of the second raised portion in the horizontal direction.

13. The bulk acoustic wave resonance device according to claim 1, wherein the first overlap portion extends to at least one corresponding edge of the second sub-layer in a horizontal direction, and the second overlap portion extends to at least one corresponding edge of the fourth sub-layer in the horizontal direction.

14. The bulk acoustic wave resonance device according to claim 1, wherein a thickness of the first extension portion is less than a thickness of the first electrode layer, and a thickness of the second extension portion is less than a thickness of the second electrode layer.

15. The bulk acoustic wave resonance device according to claim 1, wherein the first extension portion comprises a first sub-portion and a second sub-portion, the second sub-portion and the piezoelectric layer are disposed at two opposite sides of the first sub-portion, and a material of the first sub-portion is different from a material of the second sub-portion; and/or
wherein the second extension portion comprises a third sub-portion and a fourth sub-portion, the fourth sub-portion and the piezoelectric layer are disposed at two opposite sides of the third sub-portion, and a material of the third sub-portion is different from a material of the fourth sub-portion.

16. The bulk acoustic wave resonance device according to claim 1, wherein the first passivation portion is made of a dielectric material, and the second passivation portion is made of a dielectric material.

17. The bulk acoustic wave resonance device according to claim 1, wherein the first passivation portion is further disposed between the piezoelectric layer and the first extension portion, and the second passivation portion is further disposed between the piezoelectric layer and the second extension portion.

18. The bulk acoustic wave resonance device according to claim 1, wherein a first gap is disposed between the first extension portion and the piezoelectric layer, and a second gap is disposed between the piezoelectric layer and the second extension portion.

19. A filtering device, comprising at least one bulk acoustic wave resonance device according to any one of claims 1 to 18.

20. A method for forming a bulk acoustic wave resonance device (300), comprising:
forming a piezoelectric layer (3001), wherein the piezoelectric layer comprises a first side and a second side opposite to the first side in a vertical direction;
forming a first electrode layer (3004) at the first side, wherein forming the first electrode layer comprises forming a first sub-layer (a) and a second sub-layer (b) contacting the first sub-layer, and the first sub-layer, disposed between the second sub-layer and the piezoelectric layer, contacts the piezoelectric layer;
forming a second electrode layer (3006) at the second side, wherein forming the second electrode layer comprises forming a third sub-layer (c) and a fourth sub-layer (d) contacting the third sub-layer, the third sub-layer, disposed between the fourth sub-layer and the piezoelectric layer, contacts the piezoelectric layer, and an overlap region of the first sub-layer, the third sub-layer and the piezoelectric layer forms a resonance region;
forming a first passive structure (3012) at the first side, wherein the first passive structure contacts at least one edge of the first sub-layer; wherein the first passive structure comprises a first raised portion (3015), a first passivation portion (3008) and a first extension portion (3016), and the first raised portion protrudes relative to the first extension portion; wherein the first raised portion, disposed in the resonance region, has a first overlap portion overlapping with the at least one edge of the first sub-layer, and the first raised portion is configured to make acoustic impedance matching of the resonance region and at least one evanescent region outside the resonance region, so that more acoustic waves generated in the resonance region enter the at least one evanescent region; wherein the first passivation portion is disposed between the first raised portion and the first electrode layer for electrically isolating the first passive structure from the first electrode layer, and the first passivation portion contacts the at least one edge of the first sub-layer; wherein the first extension portion is disposed outside the resonance region and in the at least one evanescent region for decaying the acoustic waves entering the at least one evanescent region; and
forming a second passive structure (3013) at the second side, wherein the second passive structure contacts at least one edge of the third sub-layer; wherein the second passive structure comprises a second raised portion (3017), a second passivation portion (3009) and a second extension portion (3018), and the second raised portion protrudes relative to the second extension portion; wherein the second raised portion, disposed in the resonance region, has a second overlap portion overlapping with the at least one edge of the third sub-layer, and the second raised portion is configured to make acoustic impedance matching of the resonance region and the at least one evanescent region, so that more acoustic waves generated in the resonance region enter the at least one evanescent region; wherein the second passivation portion is disposed between the second raised portion and the second electrode layer for electrically isolating the second passive structure from the second electrode layer, and the second passivation portion contacts the at least one edge of the third sub-layer; wherein the second extension portion is disposed outside the resonance region and in the at least one evanescent region for decaying the acoustic waves entering the at least one evanescent region.

21. The method according to claim 20, wherein forming the first sub-layer comprises forming a first ramp-down edge corresponding to the first passive structure, and forming the third sub-layer comprises forming a second ramp-down edge corresponding to the second passive structure.

22. The method according to claim 20, wherein forming the first passive structure comprises:
forming a first passivation layer covering the first electrode layer at the first side; and
forming a first overlap layer contacting the first passivation layer and having an overlap portion overlapping with the at least one edge of the first sub-layer;
wherein the first passivation layer comprises the first passivation portion, and the first overlap layer comprises the first raised portion and the first extension portion;
and/or
wherein forming the second passive structure comprises:
forming a second passivation layer covering the second electrode layer at the second side; and
forming a second overlap layer contacting the second passivation layer and having an overlap portion overlapping with the at least one edge of the third sub-layer;
wherein the second passivation layer comprises the second passivation portion, and the second overlap layer comprises the second raised portion and the second extension portion.

23. The method according to claim 20, further comprising:
forming a first electrode extension layer at the first side, wherein the first electrode extension layer is coupled with the first electrode layer; and
forming a second electrode extension layer at the second side, wherein the second electrode extension layer is coupled with the second electrode layer.

24. The method according to claim 22, wherein forming the first overlap layer comprises forming a first overlap sub-layer and a second overlap sub-layer, the second overlap sub-layer and the piezoelectric layer are disposed at two opposite sides of the first overlap sub-layer, and a material of the first overlap sub-layer is different from a material of the second overlap sub-layer; and/or
wherein forming the second overlap layer comprises forming a third overlap sub-layer and a fourth overlap sub-layer, the fourth overlap sub-layer and the piezoelectric layer are disposed at two opposite sides of the third overlap sub-layer, and a material of the third overlap sub-layer is different from a material of the fourth overlap sub-layer.

25. The method according to claim 20, further comprising:
forming a first sacrificial layer between the first extension portion and the piezoelectric layer; and
forming a second sacrificial layer between the second extension portion and the piezoelectric layer;
removing the first sacrificial layer to form a first gap between the first extension portion and the piezoelectric layer; and
removing the second sacrificial layer to form a second gap between the second extension portion and the piezoelectric layer.

## Patentansprüche

1. Volumenschallwellenresonanzvorrichtung (300), umfassend:
einen Hohlraum (3014);
eine erste Elektrodenschicht (3004), wobei mindestens ein Ende der ersten Elektrodenschicht über oder in dem Hohlraum angeordnet ist und die erste Elektrodenschicht eine erste Teilschicht (a) und eine zweite Teilschicht (b) umfasst, die die erste Teilschicht kontaktiert;
eine piezoelektrische Schicht (3001), wobei die piezoelektrische Schicht eine erste Seite und eine zweite Seite aufweist, die der ersten Seite in der vertikalen Richtung gegenüberliegt, wobei der Hohlraum an der ersten Seite angeordnet ist, die erste Elektrodenschicht an der ersten Seite angeordnet ist und die erste Teilschicht, die zwischen der zweiten Teilschicht und der piezoelektrischen Schicht angeordnet ist, die piezoelektrische Schicht kontaktiert;
eine zweite Elektrodenschicht (3006), die an der zweiten Seite angeordnet ist, wobei die zweite Elektrodenschicht eine dritte Teilschicht (c) und eine vierte Teilschicht (d) umfasst, die die dritte Teilschicht kontaktiert, wobei die dritte Teilschicht, die zwischen der vierten Teilschicht und der piezoelektrischen Schicht angeordnet ist, die piezoelektrische Schicht kontaktiert, und wobei ein Überlappungsbereich der ersten Teilschicht, der dritten Teilschicht und der piezoelektrischen Schicht einen Resonanzbereich bildet;
eine erste passive Struktur (3012), die an der ersten Seite angeordnet ist und mindestens eine Kante der ersten Teilschicht kontaktiert; und
eine zweite passive Struktur (3013), die an der zweiten Seite angeordnet ist und mindestens eine Kante der dritten Teilschicht kontaktiert;
wobei die erste passive Struktur umfasst:
einen ersten erhöhten Abschnitt (3015), der im Resonanzbereich angeordnet ist und einen ersten Überlappungsabschnitt aufweist, der mit der mindestens einen Kante der ersten Teilschicht überlappt, wobei der erste erhöhte Abschnitt derart ausgebildet ist, dass er eine Impedanzanpassung zwischen dem Resonanzbereich und mindestens einem evaneszenten Bereich ausserhalb des Resonanzbereichs bewirkt, sodass mehr im Resonanzbereich erzeugte Schallwellen in den mindestens einen evaneszenten Bereich eintreten;
einen ersten Passivierungsabschnitt (3008), der zwischen dem ersten erhöhten Abschnitt und der ersten Elektrodenschicht angeordnet ist, um die erste passive Struktur elektrisch von der ersten Elektrodenschicht zu isolieren; und
einen ersten Verlängerungsabschnitt (3016), der ausserhalb des Resonanzbereichs und in dem mindestens einen evaneszenten Bereich angeordnet ist, um die in den mindestens einen evaneszenten Bereich eintretenden Schallwellen abklingen zu lassen, wobei der erste erhöhte Abschnitt relativ zum ersten Verlängerungsabschnitt hervorsteht;
wobei die zweite passive Struktur umfasst:
einen zweiten erhöhten Abschnitt (3017), der im Resonanzbereich angeordnet ist und einen zweiten Überlappungsabschnitt aufweist, der mit der mindestens einen Kante der dritten Teilschicht überlappt, wobei der zweite erhöhte Abschnitt so ausgebildet ist, dass er eine Impedanzanpassung zwischen dem Resonanzbereich und dem mindestens einen evaneszenten Bereich bewirkt, sodass mehr im Resonanzbereich erzeugte Schallwellen in den mindestens einen evaneszenten Bereich eintreten;
einen zweiten Passivierungsabschnitt (3009), der zwischen dem zweiten erhöhten Abschnitt und der zweiten Elektrodenschicht angeordnet ist, um die zweite passive Struktur elektrisch von der zweiten Elektrodenschicht zu isolieren; und
einen zweiten Verlängerungsabschnitt (3018), der ausserhalb des Resonanzbereichs und in dem mindestens einen evaneszenten Bereich angeordnet ist, um die in den mindestens einen evaneszenten Bereich eintretenden Schallwellen abklingen zu lassen, wobei der zweite erhöhte Abschnitt relativ zum zweiten Verlängerungsabschnitt hervorsteht.

2. Volumenschallwellenresonanzvorrichtung nach Anspruch 1, wobei die mindestens eine Kante der ersten Teilschicht, die der ersten passiven Struktur entspricht, eine abfallende Rampenform aufweist, und die mindestens eine Kante der dritten Teilschicht, die der zweiten passiven Struktur entspricht, eine abfallende Rampenform aufweist.

3. Volumenschallwellenresonanzvorrichtung nach Anspruch 1, wobei eine Dimension der zweiten Teilschicht kleiner ist als eine Dimension der ersten Teilschicht und eine Dimension der vierten Teilschicht kleiner ist als eine Dimension der dritten Teilschicht.

4. Volumenschallwellenresonanzvorrichtung nach Anspruch 1, wobei mindestens eine Kante der zweiten Teilschicht an einer inneren Seite als mindestens eine entsprechende Kante der ersten Teilschicht angeordnet ist und mindestens eine Kante der vierten Teilschicht an einer inneren Seite als mindestens eine entsprechende Kante der dritten Teilschicht angeordnet ist.

5. Volumenschallwellenresonanzvorrichtung nach Anspruch 1, wobei die erste passive Struktur und die zweite passive Struktur den Resonanzbereich umgeben.

6. Volumenschallwellenresonanzvorrichtung nach Anspruch 1, wobei eine Dicke der ersten passiven Struktur gleich oder kleiner als eine Dicke der ersten Elektrodenschicht ist und eine Dicke der zweiten passiven Struktur gleich oder kleiner als eine Dicke der zweiten Elektrodenschicht ist.

7. Volumenschallwellenresonanzvorrichtung nach Anspruch 1, wobei der mindestens eine evaneszente Bereich einen ersten evaneszenten Bereich umfasst, der eine erste Grenzfrequenz aufweist, die gleich oder kleiner als eine Grenzfrequenz des Resonanzbereichs ist, und der erste evaneszente Bereich einem Überlappungsbereich des ersten Verlängerungsabschnitts, der piezoelektrischen Schicht und des zweiten Verlängerungsabschnitts entspricht.

8. Volumenschallwellenresonanzvorrichtung nach Anspruch 1, die weiter umfasst:
eine erste Elektrodenverlängerungsschicht, die an der ersten Seite angeordnet und mit der ersten Elektrodenschicht gekoppelt ist; und
eine zweite Elektrodenverlängerungsschicht, die an der zweiten Seite angeordnet und mit der zweiten Elektrodenschicht gekoppelt ist.

9. Volumenschallwellenresonanzvorrichtung nach Anspruch 8, wobei der mindestens eine evaneszente Bereich einen zweiten evaneszenten Bereich umfasst, der eine zweite Grenzfrequenz aufweist, die gleich oder kleiner als eine Grenzfrequenz des Resonanzbereichs ist, und der zweite evaneszente Bereich einem Überlappungsbereich der zweiten Elektrodenverlängerungsschicht, der piezoelektrischen Schicht und des ersten Verlängerungsabschnitts entspricht; und/oder
wobei der mindestens eine evaneszente Bereich einen dritten evaneszenten Bereich umfasst, der eine dritte Grenzfrequenz aufweist, die gleich oder kleiner als die Grenzfrequenz des Resonanzbereichs ist, und der dritte evaneszente Bereich einem Überlappungsbereich des zweiten Verlängerungsabschnitts, der piezoelektrischen Schicht und der ersten Elektrodenverlängerungsschicht entspricht.

10. Volumenschallwellenresonanzvorrichtung nach Anspruch 1, wobei eine Breite des ersten erhöhten Abschnitts ein ganzzahliges Vielfaches einer halben Wellenlänge der im Resonanzbereich erzeugten Schallwellen ist und eine Breite des zweiten erhöhten Abschnitts ein ganzzahliges Vielfaches der halben Wellenlänge der im Resonanzbereich erzeugten Schallwellen ist.

11. Volumenschallwellenresonanzvorrichtung nach Anspruch 1, wobei der erste erhöhte Abschnitt aus einem Material besteht, das ein Metall enthält, der erste Verlängerungsabschnitt aus einem Material besteht, das ein Metall enthält, der zweite erhöhte Abschnitt aus einem Material besteht, das ein Metall enthält, und der zweite Verlängerungsabschnitt aus einem Material besteht, das ein Metall enthält.

12. Volumenschallwellenresonanzvorrichtung nach Anspruch 1, wobei die erste Teilschicht an einer Seite des ersten erhöhten Abschnitts in vertikaler Richtung angeordnet ist, die zweite Teilschicht an einer Seite des ersten erhöhten Abschnitts in horizontaler Richtung angeordnet ist, die dritte Teilschicht an einer Seite des zweiten erhöhten Abschnitts in vertikaler Richtung angeordnet ist und die vierte Teilschicht an einer Seite des zweiten erhöhten Abschnitts in horizontaler Richtung angeordnet ist.

13. Volumenschallwellenresonanzvorrichtung nach Anspruch 1, wobei sich der erste Überlappungsabschnitt in horizontaler Richtung bis zu mindestens einer entsprechenden Kante der zweiten Teilschicht erstreckt und sich der zweite Überlappungsabschnitt in horizontaler Richtung bis zu mindestens einer entsprechenden Kante der vierten Teilschicht erstreckt.

14. Volumenschallwellenresonanzvorrichtung nach Anspruch 1, wobei eine Dicke des ersten Verlängerungsabschnitts geringer ist als eine Dicke der ersten Elektrodenschicht und eine Dicke des zweiten Verlängerungsabschnitts geringer ist als eine Dicke der zweiten Elektrodenschicht.

15. Volumenschallwellenresonanzvorrichtung nach Anspruch 1, wobei der erste Verlängerungsabschnitt einen ersten Teilabschnitt und einen zweiten Teilabschnitt umfasst, der zweite Teilabschnitt und die piezoelektrische Schicht an zwei gegenüberliegenden Seiten des ersten Teilabschnitts angeordnet sind und sich das Material des ersten Teilabschnitts von dem Material des zweiten Teilabschnitts unterscheidet; und/oder
wobei der zweite Verlängerungsabschnitt einen dritten Teilabschnitt und einen vierten Teilabschnitt umfasst, wobei der vierte Teilabschnitt und die piezoelektrische Schicht an zwei gegenüberliegenden Seiten des dritten Teilabschnitts angeordnet sind und sich das Material des dritten Teilabschnitts von dem Material des vierten Teilabschnitts unterscheidet.

16. Volumenschallwellenresonanzvorrichtung nach Anspruch 1, wobei der erste Passivierungsabschnitt aus einem dielektrischen Material besteht und der zweite Passivierungsabschnitt aus einem dielektrischen Material besteht.

17. Volumenschallwellenresonanzvorrichtung nach Anspruch 1, wobei der erste Passivierungsabschnitt weiter zwischen der piezoelektrischen Schicht und dem ersten Verlängerungsabschnitt angeordnet ist und der zweite Passivierungsabschnitt weiter zwischen der piezoelektrischen Schicht und dem zweiten Verlängerungsabschnitt angeordnet ist.

18. Volumenschallwellenresonanzvorrichtung nach Anspruch 1, wobei ein erster Spalt zwischen dem ersten Verlängerungsabschnitt und der piezoelektrischen Schicht angeordnet ist und ein zweiter Spalt zwischen der piezoelektrischen Schicht und dem zweiten Verlängerungsabschnitt angeordnet ist.

19. Filtervorrichtung, umfassend mindestens eine Volumenschallwellenresonanzvorrichtung nach einem der Ansprüche 1 bis 18.

20. Verfahren zum Herstellen einer Volumenschallwellenresonanzvorrichtung (300), umfassend:
Bilden einer piezoelektrischen Schicht (3001), wobei die piezoelektrische Schicht eine erste Seite und eine zweite Seite umfasst, die der ersten Seite in der vertikalen Richtung gegenüberliegt;
Bilden einer ersten Elektrodenschicht (3004) an der ersten Seite, wobei das Bilden der ersten Elektrodenschicht das Bilden einer ersten Teilschicht (a) und einer zweiten Teilschicht (b), die die erste Teilschicht kontaktiert, umfasst, und die erste Teilschicht, die zwischen der zweiten Teilschicht und der piezoelektrischen Schicht angeordnet ist, die piezoelektrische Schicht kontaktiert;
Bilden einer zweiten Elektrodenschicht (3006) an der zweiten Seite, wobei das Bilden der zweiten Elektrodenschicht das Bilden einer dritten Teilschicht (c) und einer vierten Teilschicht (d), die die dritte Teilschicht kontaktiert, umfasst, wobei die dritte Teilschicht, die zwischen der vierten Teilschicht und der piezoelektrischen Schicht angeordnet ist, die piezoelektrische Schicht kontaktiert, und ein Überlappungsbereich der ersten Teilschicht, die dritte Teilschicht und die piezoelektrische Schicht einen Resonanzbereich bilden;
Bilden einer ersten passiven Struktur (3012) an der ersten Seite, wobei die erste passive Struktur mindestens eine Kante der ersten Teilschicht kontaktiert; wobei die erste passive Struktur einen ersten erhöhten Abschnitt (3015), einen ersten Passivierungsabschnitt (3008) und einen ersten Verlängerungsabschnitt (3016) umfasst, und der erste erhöhte Abschnitt relativ zum ersten Verlängerungsabschnitt hervorsteht; wobei der erste erhöhte Abschnitt, der im Resonanzbereich angeordnet ist, einen ersten Überlappungsabschnitt aufweist, der mit der mindestens einen Kante der ersten Teilschicht überlappt, und der erste erhöhte Abschnitt derart ausgebildet ist, dass er eine Impedanzanpassung zwischen dem Resonanzbereich und mindestens einem evaneszenten Bereich ausserhalb des Resonanzbereichs bewirkt, sodass mehr im Resonanzbereich erzeugte Schallwellen in den mindestens einen evaneszenten Bereich eintreten; wobei der erste Passivierungsabschnitt zwischen dem ersten erhöhten Abschnitt und der ersten Elektrodenschicht angeordnet ist, um die erste passive Struktur elektrisch von der ersten Elektrodenschicht zu isolieren, und der erste Passivierungsabschnitt die mindestens eine Kante der ersten Teilschicht kontaktiert; wobei der erste Verlängerungsabschnitt ausserhalb des Resonanzbereichs und in dem mindestens einen evaneszenten Bereich angeordnet ist, um die in den mindestens einen evaneszenten Bereich eintretenden Schallwellen abklingen zu lassen; und
Bilden einer zweiten passiven Struktur (3013) an der zweiten Seite, wobei die zweite passive Struktur mindestens eine Kante der dritten Teilschicht kontaktiert; wobei die zweite passive Struktur einen zweiten erhöhten Abschnitt (3017), einen zweiten Passivierungsabschnitt (3009) und einen zweiten Verlängerungsabschnitt (3018) umfasst, und der zweite erhöhte Abschnitt relativ zum zweiten Verlängerungsabschnitt hervorsteht; wobei der zweite erhöhte Abschnitt, der im Resonanzbereich angeordnet ist, einen zweiten Überlappungsabschnitt aufweist, der mit der mindestens einen Kante der dritten Teilschicht überlappt, und der zweite erhöhte Abschnitt derart ausgebildet ist, dass er eine Impedanzanpassung zwischen dem Resonanzbereich und dem mindestens einen evaneszenten Bereich bewirkt, sodass mehr im Resonanzbereich erzeugte Schallwellen in den mindestens einen evaneszenten Bereich eintreten; wobei der zweite Passivierungsabschnitt zwischen dem zweiten erhöhten Abschnitt und der zweiten Elektrodenschicht angeordnet ist, um die zweite passive Struktur elektrisch von der zweiten Elektrodenschicht zu isolieren, und der zweite Passivierungsabschnitt die mindestens eine Kante der dritten Teilschicht kontaktiert; wobei der zweite Verlängerungsabschnitt ausserhalb des Resonanzbereichs und in dem mindestens einen evaneszenten Bereich angeordnet ist, um die in den mindestens einen evaneszenten Bereich eintretenden Schallwellen abklingen zu lassen.

21. Verfahren nach Anspruch 20, wobei das Bilden der ersten Teilschicht das Bilden einer ersten abfallenden Kante entsprechend der ersten passiven Struktur umfasst und das Bilden der dritten Teilschicht das Bilden einer zweiten abfallenden Kante entsprechend der zweiten passiven Struktur umfasst.

22. Verfahren nach Anspruch 20, wobei das Bilden der ersten passiven Struktur umfasst:
Bilden einer ersten Passivierungsschicht, die die erste Elektrodenschicht auf der ersten Seite bedeckt; und
Bilden einer ersten Überlappungsschicht, die mit der ersten Passivierungsschicht in Kontakt steht und einen Überlappungsabschnitt aufweist, der mit der mindestens einen Kante der ersten Teilschicht überlappt;
wobei die erste Passivierungsschicht den ersten Passivierungsabschnitt umfasst und die erste Überlappungsschicht den ersten erhöhten Abschnitt und den ersten Verlängerungsabschnitt umfasst; und/oder
wobei das Bilden der zweiten passiven Struktur umfasst:
Bilden einer zweiten Passivierungsschicht, die die zweite Elektrodenschicht auf der zweiten Seite bedeckt; und
Bilden einer zweiten Überlappungsschicht, die mit der zweiten Passivierungsschicht in Kontakt steht und einen Überlappungsabschnitt aufweist, der mit der mindestens einen Kante der dritten Teilschicht überlappt;
wobei die zweite Passivierungsschicht den zweiten Passivierungsabschnitt umfasst und die zweite Überlappungsschicht den zweiten erhöhten Abschnitt und den zweiten Verlängerungsabschnitt umfasst.

23. Verfahren nach Anspruch 20, das weiter umfasst:
Bilden einer ersten Elektrodenverlängerungsschicht an der ersten Seite, wobei die erste Elektrodenverlängerungsschicht mit der ersten Elektrodenschicht gekoppelt ist; und
Bilden einer zweiten Elektrodenverlängerungsschicht an der zweiten Seite, wobei die zweite Elektrodenverlängerungsschicht mit der zweiten Elektrodenschicht gekoppelt ist.

24. Verfahren nach Anspruch 22, wobei das Bilden der ersten Überlappungsschicht das Bilden einer ersten Überlappungs-Teilschicht und einer zweiten Überlappungs-Teilschicht umfasst, wobei die zweite Überlappungs-Teilschicht und die piezoelektrische Schicht an zwei gegenüberliegenden Seiten der ersten Überlappungs-Teilschicht angeordnet sind und sich ein Material der ersten Überlappungs-Teilschicht von einem Material der zweiten Überlappungs-Teilschicht unterscheidet; und/oder
wobei das Bilden der zweiten Überlappungsschicht das Bilden einer dritten Überlappungs-Teilschicht und einer vierten Überlappungs-Teilschicht umfasst, wobei die vierte Überlappungs-Teilschicht und die piezoelektrische Schicht an zwei gegenüberliegenden Seiten der dritten Überlappungs-Teilschicht angeordnet sind und sich ein Material der dritten Überlappungs-Teilschicht von einem Material der vierten Überlappungs-Teilschicht unterscheidet.

25. Verfahren nach Anspruch 20, weiter umfassend:
Bilden einer ersten Opferschicht zwischen dem ersten Verlängerungsabschnitt und der piezoelektrischen Schicht; und
Bilden einer zweiten Opferschicht zwischen dem zweiten Verlängerungsabschnitt und der piezoelektrischen Schicht;
Entfernen der ersten Opferschicht, um einen ersten Spalt zwischen dem ersten Verlängerungsabschnitt und der piezoelektrischen Schicht zu bilden; und
Entfernen der zweiten Opferschicht, um einen zweiten Spalt zwischen dem zweiten Verlängerungsabschnitt und der piezoelektrischen Schicht zu bilden.

## Revendications

1. Un dispositif à résonance d'ondes acoustiques de volume, comprenant :
une cavité (3014) ;
une première couche d'électrode (3004), dans laquelle au moins une extrémité de la première couche d'électrode est disposée au-dessus ou à l'intérieur de la cavité, et la première couche d'électrode comprend une première sous-couche (a) et une deuxième sous-couche (b) en contact avec la première sous-couche ;
une couche piézoélectrique (3001), dans laquelle la couche piézoélectrique comprend une première face et une deuxième face opposée à la première face dans une direction verticale, la cavité étant disposée au niveau de la première face, la première couche d'électrode étant disposée au niveau de la première face, et la première sous-couche, disposée entre la deuxième sous-couche et la couche piézoélectrique, étant en contact avec la couche piézoélectrique ;
une deuxième couche d'électrode (3006), disposée au niveau de la deuxième face, dans laquelle la deuxième couche d'électrode comprend une troisième sous-couche (c) et une quatrième sous-couche (d) en contact avec la troisième sous-couche, la troisième sous-couche étant disposée entre la quatrième sous-couche et la couche piézoélectrique, est en contact avec la couche piézoélectrique, et une zone de chevauchement de la première sous-couche, de la troisième sous-couche et de la couche piézoélectrique forme une zone de résonance ;
une première structure passive (3012), disposée sur le premier côté et en contact avec au moins un bord de la première sous-couche ; et
une deuxième structure passive (3013), disposée sur le deuxième côté et en contact avec au moins un bord de la troisième sous-couche ;
dans lequel la première structure passive comprend :
une première partie surélevée (3015), disposée dans la zone de résonance et comportant une première partie de chevauchement qui chevauche ledit au moins un bord de la première sous-couche, ladite première partie surélevée étant configurée pour assurer l'adaptation d'impédance acoustique entre la zone de résonance et au moins une zone évanescente située à l'extérieur de la zone de résonance, de sorte qu'un plus grand nombre d'ondes acoustiques générées dans la zone de résonance pénètrent dans ladite au moins une zone évanescente ;
une première partie de passivation (3008), disposée entre la première partie surélevée et la première couche d'électrode afin d'isoler électriquement la première structure passive de la première couche d'électrode ; et
une première partie d'extension (3016), disposée à l'extérieur de la région de résonance et dans ladite au moins une région évanescente afin d'atténuer les ondes acoustiques pénétrant dans ladite au moins une région évanescente, la première partie surélevée faisant saillie par rapport à la première partie d'extension ;
dans laquelle la deuxième structure passive comprend :
une deuxième partie surélevée (3017), disposée dans la zone de résonance et comportant une deuxième partie de chevauchement qui chevauche au moins un bord de la troisième sous-couche, la deuxième partie surélevée étant configurée pour assurer l'adaptation d'impédance acoustique entre la zone de résonance et l'au moins une zone évanescente, de sorte que davantage d'ondes acoustiques générées dans la zone de résonance pénètrent dans l'au moins une zone évanescente ;
une deuxième partie de passivation (3009), disposée entre la deuxième partie surélevée et la deuxième couche d'électrode afin d'isoler électriquement la deuxième structure passive de la deuxième couche d'électrode ; et
une deuxième partie d'extension (3018), disposée à l'extérieur de la région de résonance et dans l'au moins une région évanescente afin d'atténuer les ondes acoustiques pénétrant dans l'au moins une région évanescente, la deuxième partie surélevée faisant saillie par rapport à la deuxième partie d'extension.

2. Le dispositif de résonance d'ondes acoustiques de volume selon la revendication 1, dans lequel l'au moins un bord de la première sous-couche, correspondant à la première structure passive, présente une forme en pente descendante, et l'au moins un bord de la troisième sous-couche, correspondant à la deuxième structure passive, présente une forme en pente descendante.

3. Le dispositif de résonance à ondes acoustiques de volume selon la revendication 1, dans lequel une dimension de la deuxième sous-couche est inférieure à une dimension de la première sous-couche, et une dimension de la quatrième sous-couche est inférieure à une dimension de la troisième sous-couche.

4. Le dispositif de résonance à ondes acoustiques de volume selon la revendication 1, dans lequel au moins un bord de la deuxième sous-couche est disposé sur un bord intérieur d'au moins un bord correspondant de la première sous-couche, et au moins un bord de la quatrième sous-couche est disposé en deçà d'au moins un bord correspondant de la troisième sous-couche.

5. Le dispositif de résonance à ondes acoustiques de volume selon la revendication 1, dans lequel la première structure passive et la deuxième structure passive entourent la région de résonance.

6. Le dispositif de résonance à ondes acoustiques de volume selon la revendication 1, dans lequel l'épaisseur de la première structure passive est égale ou inférieure à l'épaisseur de la première couche d'électrode, et l'épaisseur de la deuxième structure passive est égale ou inférieure à l'épaisseur de la deuxième couche d'électrode.

7. Le dispositif de résonance à ondes acoustiques de volume selon la revendication 1, dans lequel l'au moins une région évanescente comprend une première région évanescente ayant une première fréquence de coupure égale ou inférieure à une fréquence de coupure de la région de résonance, et la première région évanescente correspond à une région de chevauchement de la première partie d'extension, de la couche piézoélectrique et de la deuxième partie d'extension.

8. Le dispositif de résonance à ondes acoustiques de volume selon la revendication 1, comprenant en outre :
une première couche d'extension d'électrode, disposée sur le premier côté et couplée à la première couche d'électrode ; et
une deuxième couche d'extension d'électrode, disposée sur le deuxième côté et couplée à la deuxième couche d'électrode.

9. Le dispositif de résonance à ondes acoustiques de volume selon la revendication 8, dans lequel l'au moins une région évanescente comprend une deuxième région évanescente ayant une deuxième fréquence de coupure égale ou inférieure à une fréquence de coupure de la région de résonance, et la deuxième région évanescente correspond à une région de chevauchement de la deuxième couche d'extension d'électrode, de la couche piézoélectrique et de la première partie d'extension ; et/ou
dans lequel ladite au moins une région évanescente comprend une troisième région évanescente ayant une troisième fréquence de coupure égale ou inférieure à la fréquence de coupure de la région de résonance, et ladite troisième région évanescente correspond à une région de chevauchement de ladite deuxième partie d'extension, de ladite couche piézoélectrique et de ladite première couche d'extension d'électrode.

10. Le dispositif de résonance à ondes acoustiques de volume selon la revendication 1, dans lequel la largeur de la première partie surélevée est un multiple entier d'une demi-longueur d'onde des ondes acoustiques générées dans la région de résonance, et la largeur de la deuxième partie surélevée est un multiple entier de la demi-longueur d'onde des ondes acoustiques générées dans la région de résonance.

11. Le dispositif de résonance d'ondes acoustiques de volume selon la revendication 1, dans lequel la première partie surélevée est constituée d'un matériau comprenant un métal, la première partie d'extension est constituée d'un matériau comprenant un métal, la deuxième partie surélevée est constituée d'un matériau comprenant un métal, et la deuxième partie d'extension est constituée d'un matériau comprenant un métal.

12. Le dispositif de résonance à ondes acoustiques de volume selon la revendication 1, dans lequel la première sous-couche est disposée sur un côté de la première partie surélevée dans la direction verticale, la deuxième sous-couche est disposée sur un côté de la première partie surélevée dans la direction horizontale, la troisième sous-couche est disposée sur un côté de la deuxième partie surélevée dans la direction verticale, et la quatrième sous-couche est disposée sur un côté de la deuxième partie surélevée dans la direction horizontale.

13. Le dispositif de résonance à ondes acoustiques de volume selon la revendication 1, dans lequel la première partie de chevauchement s'étend jusqu'à au moins un bord correspondant de la deuxième sous-couche dans une direction horizontale, et la deuxième partie de chevauchement s'étend jusqu'à au moins un bord correspondant de la quatrième sous-couche dans la direction horizontale.

14. Le dispositif de résonance à ondes acoustiques de volume selon la revendication 1, dans lequel l'épaisseur de la première partie d'extension est inférieure à l'épaisseur de la première couche d'électrode, et l'épaisseur de la deuxième partie d'extension est inférieure à l'épaisseur de la deuxième couche d'électrode.

15. Le dispositif de résonance à ondes acoustiques de volume selon la revendication 1, dans lequel la première partie d'extension comprend une première sous-partie et une deuxième sous-partie, la deuxième sous-partie et la couche piézoélectrique sont disposées de part et d'autre de la première sous-partie, et le matériau de la première sous-partie est différent de celui de la deuxième sous-partie ; et/ou
dans lequel la deuxième partie d'extension comprend une troisième sous-partie et une quatrième sous-partie, la quatrième sous-partie et la couche piézoélectrique sont disposées de part et d'autre de la troisième sous-partie, et le matériau de la troisième sous-partie est différent de celui de la quatrième sous-partie.

16. Le dispositif de résonance à ondes acoustiques de volume selon la revendication 1, dans lequel la première partie de passivation est constituée d'un matériau diélectrique, et la deuxième partie de passivation est constituée d'un matériau diélectrique.

17. Le dispositif de résonance à ondes acoustiques de volume selon la revendication 1, dans lequel la première partie de passivation est en outre disposée entre la couche piézoélectrique et la première partie d'extension, et la deuxième partie de passivation est en outre disposée entre la couche piézoélectrique et la deuxième partie d'extension.

18. Le dispositif de résonance à ondes acoustiques de volume selon la revendication 1, dans lequel un premier espace est disposé entre la première partie d'extension et la couche piézoélectrique, et un deuxième espace est disposé entre la couche piézoélectrique et la deuxième partie d'extension.

19. Un dispositif de filtrage, comprenant au moins un dispositif de résonance à ondes acoustiques de volume selon l'une quelconque des revendications 1 à 18.

20. Un procédé de formation d'un dispositif de résonance à ondes acoustiques de volume (300), comprenant :
la formation d'une couche piézoélectrique (3001), la couche piézoélectrique comportant une première face et une deuxième face opposée à la première face dans une direction verticale ;
la formation d'une première couche d'électrode (3004) sur la première face, la formation de la première couche d'électrode comprenant la formation d'une première sous-couche (a) et d'une deuxième sous-couche (b) en contact avec la première sous-couche, et la première sous-couche, disposée entre la deuxième sous-couche et la couche piézoélectrique, étant en contact avec la couche piézoélectrique ;
la formation d'une deuxième couche d'électrode (3006) sur la deuxième face, la formation de la deuxième couche d'électrode comprenant la formation d'une troisième sous-couche (c) et d'une quatrième sous-couche (d) en contact avec la troisième sous-couche, la troisième sous-couche, disposée entre la quatrième sous-couche et la couche piézoélectrique, étant en contact avec la couche piézoélectrique, et une zone de chevauchement de la première sous-couche, de la troisième sous-couche et de la couche piézoélectrique formant une zone de résonance ;
former une première structure passive (3012) sur le premier côté, dans laquelle la première structure passive est en contact avec au moins un bord de la première sous-couche ; dans laquelle la première structure passive comprend une première partie surélevée (3015), une première partie de passivation (3008) et une première partie d'extension (3016), et la première partie surélevée fait saillie par rapport à la première partie d'extension ; dans laquelle la première partie surélevée, disposée dans la zone de résonance, comporte une première partie de chevauchement chevauchant ledit au moins un bord de la première sous-couche, et la première partie surélevée est configurée pour assurer l'adaptation d'impédance acoustique entre la zone de résonance et au moins une zone évanescente située à l'extérieur de la zone de résonance, de sorte qu'un plus grand nombre d'ondes acoustiques générées dans la zone de résonance pénètrent dans ladite au moins une zone évanescente ;
dans laquelle la première partie de passivation est disposée entre la première partie surélevée et la première couche d'électrode afin d'isoler électriquement la première structure passive de la première couche d'électrode, et la première partie de passivation est en contact avec ledit au moins un bord de la première sous-couche ; dans lequel la première partie d'extension est disposée à l'extérieur de la zone de résonance et dans ladite au moins une zone évanescente afin de faire s'atténuer les ondes acoustiques pénétrant dans ladite au moins une zone évanescente ; et
la formation d'une deuxième structure passive (3013) sur le deuxième côté, dans laquelle la deuxième structure passive est en contact avec au moins un bord de la troisième sous-couche ; dans laquelle la deuxième structure passive comprend une deuxième partie surélevée, une deuxième partie de passivation (3009) et une deuxième partie d'extension (3018), et la deuxième partie surélevée fait saillie par rapport à la deuxième partie d'extension ; dans laquelle la deuxième partie surélevée, disposée dans la région de résonance, comporte une deuxième partie de chevauchement chevauchant ledit au moins un bord de la troisième sous-couche, et la deuxième partie surélevée est configurée pour assurer l'adaptation d'impédance acoustique entre la région de résonance et ladite au moins une région évanescente, de sorte que davantage d'ondes acoustiques générées dans la région de résonance pénètrent dans ladite au moins une région évanescente ; dans lequel la deuxième partie de passivation est disposée entre la deuxième partie surélevée et la deuxième couche d'électrode afin d'isoler électriquement la deuxième structure passive de la deuxième couche d'électrode, et la deuxième partie de passivation est en contact avec le au moins un bord de la troisième sous-couche ; dans lequel la deuxième partie d'extension est disposée à l'extérieur de la région de résonance et dans l'au moins une région évanescente afin d'atténuer les ondes acoustiques pénétrant dans la au moins une région évanescente.

21. Le procédé selon la revendication 20, dans lequel la formation de la première sous-couche comprend la formation d'un premier bord en pente descendante correspondant à la première structure passive, et la formation de la troisième sous-couche comprend la formation d'un deuxième bord en pente descendante correspondant à la deuxième structure passive.

22. Le procédé selon la revendication 20, dans lequel la formation de la première structure passive comprend :
la formation d'une première couche de passivation recouvrant la première couche d'électrode du premier côté ; et
la formation d'une première couche de chevauchement en contact avec la première couche de passivation et comportant une partie de chevauchement chevauchant l'au moins un bord de la première sous-couche ;
dans lequel la première couche de passivation comprend la première partie de passivation, et la première couche de chevauchement comprend la première partie surélevée et la première partie d'extension ;
et/ou
dans lequel la formation de la deuxième structure passive comprend :
la formation d'une deuxième couche de passivation recouvrant la deuxième couche d'électrode sur le deuxième côté ; et
la formation d'une deuxième couche de chevauchement en contact avec la deuxième couche de passivation et comportant une partie de chevauchement chevauchant l'au moins un bord de la troisième sous-couche ;
dans lequel la deuxième couche de passivation comprend la deuxième partie de passivation, et la deuxième couche de chevauchement comprend la deuxième partie surélevée et la deuxième partie d'extension.

23. Le procédé selon la revendication 20, comprenant en outre :
la formation d'une première couche d'extension d'électrode sur le premier côté, la première couche d'extension d'électrode étant couplée à la première couche d'électrode ; et
la formation d'une deuxième couche d'extension d'électrode sur le deuxième côté, la deuxième couche d'extension d'électrode étant couplée à la deuxième couche d'électrode.

24. Le procédé selon la revendication 22, dans lequel la formation de la première couche de chevauchement comprend la formation d'une première sous-couche de chevauchement et d'une deuxième sous-couche de chevauchement, la deuxième sous-couche de chevauchement et la couche piézoélectrique étant disposées de part et d'autre de la première sous-couche de chevauchement, et le matériau de la première sous-couche de chevauchement étant différent de celui de la deuxième sous-couche de chevauchement ; et/ou
dans lequel la formation de la deuxième couche de chevauchement comprend la formation d'une troisième sous-couche de chevauchement et d'une quatrième sous-couche de chevauchement, la quatrième sous-couche de chevauchement et la couche piézoélectrique étant disposées de part et d'autre de la troisième sous-couche de chevauchement, et le matériau de la troisième sous-couche de chevauchement étant différent de celui de la quatrième sous-couche de chevauchement.

25. Le procédé selon la revendication 20, comprenant en outre :
la formation d'une première couche sacrificielle entre la première partie d'extension et la couche piézoélectrique ; et
la formation d'une deuxième couche sacrificielle entre la deuxième partie d'extension et la couche piézoélectrique ;
l'élimination de la première couche sacrificielle pour former un premier espace entre la première partie d'extension et la couche piézoélectrique ; et
l'élimination de la deuxième couche sacrificielle pour former un deuxième espace entre la deuxième partie d'extension et la couche piézoélectrique.
